# EUROPEAN PATENT APPLICATION

(11) **EP 4 603 858 A1**
(43) Date of publication of application: **20.08.2025**
(21) Application number: 24158320.2
(22) Date of filing: 19.02.2024
(51) Int. Cl.: G01R 33/54

(54) **ADJUSTMENT RECOMMENDATION FOR SCAN PARAMETERS**

(71) Applicant: Koninklijke Philips N.V., 5656 AG Eindhoven (NL)
(72) Inventor: HARDER, Tim Philipp, 5656AG Eindhoven (NL); DESHPANDE, Hrishikesh Narayanrao, 5656AG Eindhoven (NL); BUELOW, Thomas, 5656AG Eindhoven (NL); SAALBACH, Axel, 5656AG Eindhoven (NL); NORDHOFF, Tanja, 5656AG Eindhoven (NL); BERGTHOLDT, Martin, 5656AG Eindhoven (NL)
(74) Representative: Philips Intellectual Property & Standards

(57) **Abstract**

Disclosed herein is a medical system (100) comprising a computational system (402) and memory (404) storing machine-executable instructions (410) and a recommendation module (412). The recommendation module (412) is configured, using a plurality of reference datasets (320) of a plurality of reference magnetic resonance imaging data acquisitions, to output an adjustment recommendation (414) for an adjustment of at least some initial scan parameters of a first subset (302) of a definition dataset (300). The definition dataset (300) defines a magnetic resonance imaging data acquisition to be executed. An execution of the machine-executable instructions (410) causes the computational system (402) to receive the definition dataset (300), to provide the adjustment recommendation (414) using the definition dataset (300) and the recommendation module (412), and to adjust the at least some initial scan parameters of the first subset (302) using the adjustment recommendation (414).

## Description

### FIELD OF THE INVENTION

The invention relates to magnetic resonance imaging, in particular it relates to providing an adjustment recommendation for scan parameters.

### BACKGROUND OF THE INVENTION

Magnetic resonance imaging (MRI) exams, i.e., MRI data acquisition may in general comprise various options of scan sequences, which may be used acquiring the MRI data and may produce different results. MRI scan parameters determining an exact scan sequence of an MRI data acquisition executed to acquire MRI data may, e.g., be determined using standard procedures, i.e., standard scan parameters proposed for certain clinical question to be answered by the MRI data to be acquired. Such standardized approaches may in general comprise potential for an improvement of the scan parameters. However, a selection of a suitable adjustment of the standardized initial scan parameters may require the knowledge of an experienced operator. The actual result of such an adjustment, e.g., the degree of improvement being achieved, may depend on the level experience of the individual operator. For less experienced operators determining any adjustment for such initial scan parameters may be challenging. There may even be a risk of decreasing a quality of the results of an MRI data acquisition by adjusting scan parameters, rather than improving it.

### SUMMARY OF THE INVENTION

The invention provides for a medical system, a computer program, and a method in the independent claims. Embodiments are given in the dependent claims.

In one aspect, the invention provides for a medical system. The medical system comprises a memory storing machine-executable instructions and a recommendation module. The recommendation module is configured, using a plurality of reference datasets of a plurality of reference magnetic resonance imaging data acquisitions, to output an adjustment recommendation for an adjustment of at least some initial scan parameters of a first subset of a definition dataset. The definition dataset defines a magnetic resonance imaging data acquisition to be executed. The recommendation module is configured to output the adjustment recommendation in response to receiving the definition dataset as input.

The definition dataset comprises the first subset with one or more initial scan parameters proposed for the magnetic resonance imaging data acquisition, a second subset with one or more target parameters defining a physiological target type of the magnetic resonance imaging data acquisition, and a third subset with one or more physical parameters of a subject, from which magnetic resonance imaging data is to be acquired by the respective magnetic resonance imaging data acquisition.

Each of the reference datasets comprises a first reference subset with one or more initial reference scan parameters proposed for the respective reference magnetic resonance imaging data acquisition, a second reference subset with one or more reference target parameters defining a physiological target type of the respective reference magnetic resonance imaging data acquisition, a third reference subset with one or more physical reference parameters of a subject, from which magnetic resonance imaging data is acquired by the respective reference magnetic resonance imaging data acquisition, and a fourth reference subset with one or more reference scan parameter adjustments applied to the initial reference scan parameters of the respective reference magnetic resonance imaging data acquisition.

The medical system further comprises a computational system.

An execution of the machine-executable instructions causes the computational system to receive the definition dataset. The execution of the machine-executable instructions further causes the computational system to provide the adjustment recommendation using the definition dataset and the recommendation module. The execution of the machine-executable instructions further causes the computational system to adjust the at least some initial scan parameters of the first subset using the adjustment recommendation.

In another aspect, the invention provides for a computer program comprising machine-executable instructions and a recommendation module. The recommendation module is configured, using a plurality of reference datasets of a plurality of reference magnetic resonance imaging data acquisitions, to output an adjustment recommendation for an adjustment of at least some initial scan parameters of a first subset of a definition dataset. The definition dataset defines a magnetic resonance imaging data acquisition to be executed. The recommendation module is configured to output the adjustment recommendation in response to receiving the definition dataset as input.

The definition dataset comprises the first subset with one or more initial scan parameters proposed for the magnetic resonance imaging data acquisition, a second subset with one or more target parameters defining a physiological target type of the magnetic resonance imaging data acquisition, and a third subset with one or more physical parameters of a subject, from which magnetic resonance imaging data is to be acquired by the respective magnetic resonance imaging data acquisition.

Each of the reference datasets comprises a first reference subset with one or more initial reference scan parameters proposed for the respective reference magnetic resonance imaging data acquisition, a second reference subset with one or more reference target parameters defining a physiological target type of the respective reference magnetic resonance imaging data acquisition, a third reference subset with one or more physical reference parameters of a subject, from which magnetic resonance imaging data is acquired by the respective reference magnetic resonance imaging data acquisition, and a fourth reference subset with one or more reference scan parameter adjustments applied to the initial reference scan parameters of the respective reference magnetic resonance imaging data acquisition.

The machine-executable instructions are configured for causing a computational system to receive the definition dataset. The machine-executable instructions are further configured for causing the computational system to provide the adjustment recommendation using the definition dataset and the recommendation module. The machine-executable instructions are further configured for causing the computational system to adjust the at least some initial scan parameters of the first subset using the adjustment recommendation.

In another aspect, the invention provides for a method for controlling a medical system. The medical system comprises a memory storing machine-executable instructions and a recommendation module. The recommendation module is configured, using a plurality of reference datasets of a plurality of reference magnetic resonance imaging data acquisitions, to output an adjustment recommendation for an adjustment of at least some initial scan parameters of a first subset of a definition dataset. The definition dataset defines a magnetic resonance imaging data acquisition to be executed. The recommendation module is configured to output the adjustment recommendation in response to receiving the definition dataset as input.

The definition dataset comprises the first subset with one or more initial scan parameters proposed for the magnetic resonance imaging data acquisition, a second subset with one or more target parameters defining a physiological target type of the magnetic resonance imaging data acquisition, and a third subset with one or more physical parameters of a subject, from which magnetic resonance imaging data is to be acquired by the respective magnetic resonance imaging data acquisition.

Each of the reference datasets comprises a first reference subset with one or more initial reference scan parameters proposed for the respective reference magnetic resonance imaging data acquisition, a second reference subset with one or more reference target parameters defining a physiological target type of the respective reference magnetic resonance imaging data acquisition, a third reference subset with one or more physical reference parameters of a subject, from which magnetic resonance imaging data is acquired by the respective reference magnetic resonance imaging data acquisition, and a fourth reference subset with one or more reference scan parameter adjustments applied to the initial reference scan parameters of the respective reference magnetic resonance imaging data acquisition.

The medical system further comprises a computational system.

An execution of the machine-executable instructions causes the computational system to execute the method comprising receiving the definition dataset. The method further comprising providing the adjustment recommendation using the definition dataset and the recommendation module. The method further comprising adjusting the at least some initial scan parameters of the first subset using the adjustment recommendation.

### BRIEF DESCRIPTION OF THE DRAWINGS

In the following preferred embodiments of the invention will be described, by way of example only, and with reference to the drawings in which:
Fig. 1 shows a flow chart which illustrates an example of a method for providing an adjustment recommendation;
Fig. 2 shows a flow chart which illustrates an example of a method for providing a clustered plurality of reference datasets;
Fig. 3 shows a flow chart which illustrates an example of a method for determining effects of an adjustment recommendation on MRI data to be acquired;
Fig. 4 shows a flow chart which illustrates an example of a method for providing a trained machine learning module for providing an adjustment recommendation;
Fig. 5 shows a block diagram of an exemplary definition dataset;
Fig. 6 shows a block diagram of an exemplary reference dataset;
Fig. 7 shows a block diagram of an exemplary assessment dataset;
Fig. 8 illustrates a first exemplary medical system for providing an adjustment recommendation;
Fig. 9 illustrates a first exemplary medical system for providing an adjustment recommendation; and
Fig. 10 illustrates a third exemplary medical system comprising an MRI system configured for acquiring MRI data using an adjustment recommendation.

### DETAILED DESCRIPTION OF EMBODIMENTS

Like numbered elements in these figures are either equivalent elements or perform the same function. Elements which have been discussed previously will not necessarily be discussed in later figures if the function is equivalent.

In an example, a medical system comprises a memory storing machine-executable instructions and a recommendation module. The recommendation module is configured, using a plurality of reference datasets of a plurality of reference magnetic resonance imaging data acquisitions, to output an adjustment recommendation for an adjustment of at least some initial scan parameters of a first subset of a definition dataset. The definition dataset defines a magnetic resonance imaging data acquisition to be executed. The recommendation module is configured to output the adjustment recommendation in response to receiving the definition dataset as input.

The definition dataset comprises the first subset with one or more initial scan parameters proposed for the magnetic resonance imaging data acquisition, a second subset with one or more target parameters defining a physiological target type of the magnetic resonance imaging data acquisition, and a third subset with one or more physical parameters of a subject, from which magnetic resonance imaging data is to be acquired by the respective magnetic resonance imaging data acquisition.

The one or more initial scan parameters of the first subset may, e.g., comprise one or more initial scan parameters defining one or more of the following: one or more Times to Echo (TE); one or more Repetition Times (TR); one or more flip angles; one or more Inversion Times (TI); a number of acquisitions, i.e., a number of averages used; one or more scan geometry matrices; one or more slice dimensions. The one or more target parameters of the second subset may, e.g., comprise one or more target parameters defining one or more of the following: one or more internal organs, such as liver, kidney, heart, brain, etc., and/or one or more sections of the one or more internal organs; a clinical indication, such as a morphological state, an oncological state and/or a functional state, such as a cardiac function, of the respective internal organ, which is to be determined using the MRI data to be acquired. The one or more physical parameters of the third subset may, e.g., comprise one or more physical parameters defining one or more of the following: one or more general physical features of a subject, such as age, sex, weight, height; one or more physical abilities, such as an ability to hold breath; one or more features of physical constitution of the subject, such as a tremor, a low or high blood pressure, etc.

Each of the reference datasets comprises a first reference subset with one or more initial reference scan parameters proposed for the respective reference magnetic resonance imaging data acquisition, a second reference subset with one or more reference target parameters defining a physiological target type of the respective reference magnetic resonance imaging data acquisition, a third reference subset with one or more physical reference parameters of a subject, from which magnetic resonance imaging data is acquired by the respective reference magnetic resonance imaging data acquisition, and a fourth reference subset with one or more reference scan parameter adjustments applied to the initial reference scan parameters of the respective reference magnetic resonance imaging data acquisition.

The one or more initial reference scan parameters of the first reference subset may, e.g., comprise one or more initial reference scan parameters defining one or more of the following features of the reference MRI data acquisition: one or more Times to Echo (TE); one or more Repetition Times (TR); one or more flip angles; one or more Inversion Times (TI); a number of acquisitions, i.e., a number of averages used; one or more scan geometry matrices; one or more slice dimensions. The one or more reference target parameters of the second reference subset may, e.g., comprise one or more reference target parameters defining one or more of the following features of a physiological target type of the reference MRI data acquisition: one or more internal organs, such as liver, kidney, heart, brain, etc., and/or one or more sections of the one or more internal organs; a clinical indication, such as a morphological state, an oncological state and/or a functional state, such as a cardiac function, of the respective internal organ, to be determined using the reference MRI data acquisition. The one or more physical reference parameters of the third reference subset may, e.g., comprise one or more physical parameters defining one or more of the following features of the subject of the reference MRI data acquisition: one or more general physical features of a subject, such as age, sex, weight, height; one or more physical abilities, such as an ability to hold breath; one or more features of physical constitution of the subject, such as a tremor, a low or high blood pressure, etc. The one or more reference scan parameter adjustments of the fourth reference subset may, e.g., comprise one or more reference scan parameter adjustments descriptive of one or more adjustments applied to the following one or more initial reference scan parameters of reference MRI data acquisition: one or more Times to Echo (TE); one or more Repetition Times (TR); one or more flip angles; one or more Inversion Times (TI); a number of acquisitions, i.e., a number of averages used; one or more scan geometry matrices; one or more slice dimensions. These reference scan parameter adjustments may, e.g., be adjustments applied to the initial reference scan parameters of the respective reference MRI data acquisition to improve one or more of the following: a total scan time, a signal-to-noise ratio and/or a spatial resolution of the respective MRI data acquisition.

The medical system further comprises a computational system.

An execution of the machine-executable instructions causes the computational system to receive the definition dataset. The execution of the machine-executable instructions further causes the computational system to provide the adjustment recommendation using the definition dataset and the recommendation module. The execution of the machine-executable instructions further causes the computational system to adjust the at least some initial scan parameters of the first subset using the adjustment recommendation. The adjusting of the at least some initial scan parameters of the first subset using the adjustment recommendation reference scan parameter adjustments may, e.g., improve one or more of the following: a total scan time, a signal-to-noise ratio and/or a spatial resolution of the respective MRI data acquisition to be executed compared to an execution using the non-adjusted initial scan parameters.

For a magnetic resonance imaging data acquisition to be executed a set of scan parameters proposed for the magnetic resonance imaging data acquisition may be provided. These scan parameters may be referred to as initial scan parameters. The initial scan parameter may determine an exact sequence of MRI scans, i.e., one or more pulse sequences, to be executed to acquire the desired MRI data. An MRI pulse sequence may comprise a plurality of scan parameters. For example, the set of scan parameters may be provided as part of an exam-card. The exam-card may provide a list of scan sequences, i.e., pulse sequences, to be executed.

These initial scan parameters are provided as a first subset of a definition dataset. The definition dataset defines a magnetic resonance imaging data acquisition to be executed. The initial scan parameters are scan parameters proposed for executing the respective magnetic resonance imaging data acquisition. For example, these initial scan parameters may be proposed following a standard procedure for acquiring MRI data of a specific physiological target type. In addition to the first subset, the definition dataset may comprise further subsets. The subsets and thus the definition dataset may be provided in form of a single file or in distributed form comprising a plurality of files. In addition to the first subset, the definition dataset may comprise at least a second subset and a third subset. The second subset may comprise target parameters defining a physiological target type of the magnetic resonance imaging data acquisition to be executed. The third subset may comprise one or more physical parameters of a subject, from which magnetic resonance imaging data is to be acquired by the respective magnetic resonance imaging data acquisition to be executed. Using the second and third subset for providing the adjustment recommendation, individual factors of the MRI data acquisition to be executed due to the physiological target type and physical parameters of the subject may be taken into account, in order to provide an individualized adjustment recommendation.

The definition dataset is provided as an input to a recommendation module, which is configured, using a plurality of reference datasets of a plurality of reference magnetic resonance imaging data acquisitions, to output the adjustment recommendation in response to receiving the definition dataset as input. Thus, the reference datasets are used for providing the adjustment recommendation, i.e., the provided adjustment recommendation is based on reference magnetic resonance imaging data acquisitions. These reference datasets may, e.g., be provided as a clustered plurality of reference datasets, from which a cluster is selected using the definition dataset and used for determining the adjustment recommendation. These reference datasets may, e.g., be provided as training datasets used for training a machine learning module of the recommendation module to output the adjustment recommendation in response to receiving the definition dataset.

Examples may enable a usage of a plurality of reference datasets for determining the adjustment recommendation. Here, it is determined which type of scan parameter adjustments have been used in similar situations, in order to determine suitable scan parameter adjustments for a definition dataset at hand.

The plurality of reference datasets may, e.g., comprise reference datasets descriptive of reference magnetic resonance imaging data acquisition actually executed, e.g., by peer operators. The reference datasets may comprise fourth reference subsets with adjustments applied by peer operators. Thus, a peer-based adjustment recommendations may be provided. Taking further into account the patient-individual target parameters and physical parameters, i.e., taking into account the reference target parameters and the reference physical parameters, when determining the adjustment recommendation, a personalized adjustment recommendation may be provided. Thus, successful strategies used by other operators may, e.g., be used for guiding less-experienced operators through different options to update the initial scan parameters.

In order to provide the plurality of reference datasets, a large collection of data from clinical routine may be used. The respective data may, e.g., be collected retrospectively from hospital IT-systems such as picture archiving and communication systems (PACS) or electronic medical records (EMR).

Potential scan parameter adjustments described by the reference datasets may comprise datasets of best practices MRI data acquisition collected from fellow MRI operators, e.g., at the same hospital, within the same care network or even from outside peer operators.

The plurality of reference datasets may, e.g., further comprise reference datasets defined by experts. These reference datasets may be descriptive of reference magnetic resonance imaging data acquisitions as recommended by the experts. Thus, the respective reference datasets may define for certain initial scan parameters reference scan parameter adjustments to be applied to the initial scan parameters, in case MRI data is to be acquired from a certain physiological target type defined by the reference target parameters and from a certain subject defined by the more physical reference parameters. Thus, reference datasets of potential MRI data acquisitions may even be collected prospectively.

Using reference datasets defined and/or curated by experts may enable, e.g., a highlighting of new innovations, such as Compressed Sense, or a leveraging the extended understanding of the MRI image formation process. An example of the latter may, e.g., be scan area selection. In MRI, depending on the respective gradients used, a certain "volume" of a selected scan area can be imaged at the same time. If a required scan area extends beyond this volume, a second volume needs to be recorded. A recording of two volumes may result in an immediate doubling of the scan time. However, it may be possible to extend the "volume" by adjusting the initial scan parameters such that the "volume" covers the entire scan area without causing a "scan time penalty", i.e., a doubling of scan time.

Adjustments of initial scan parameters may result in improvements, like in a speed-up of a scan or in an improved image quality, like an increased signal-to-noise ratio or an improved spatial resolution of the acquired MRI data.

Examples may provide an adjustment recommendation for an adjustment of initial scan parameters. Such an adjustment may allow for an adjustment of the exam characteristics. For example, a scan time required for executing the MRI data acquisition may be reduced or an image quality of magnetic resonance images reconstructed using the MRI data being acquired may be increased. Increasing the image quality may, e.g., comprise increasing a signal-to-noise ratio of the MRI data being acquired and/or increasing a spatial resolution of the MRI data being acquired.

Example, may enable an arbitrary operator of an MRI system, even an unexperienced operator, to determine, whether an adjustment of the initial scan parameters may be recommended and/or how the initial scan parameters may be adjusted advantageously. Else, adjusting scan parameters may be challenging for a less experienced operator. Examples may prevent an operator from neglecting the possibility of adjusting initial scan parameter and/or from choosing unsuitable adjustments. Thus, sub-optimal magnetic resonance images and/or a requirement of a retake, i.e., of a repetition of the MRI data acquisition, may be avoided.

Examples provide adjustment recommendations for scan parameters, e.g., based on adjustments, which have been provided to similar or identical scan parameter in similar or identical situations. For this purpose, both clinical as well as patient specific parameters may be taken into account in form of the target parameters defining a physiological target type and the physical parameters of the subject, from which magnetic resonance imaging data is to be acquired by the respective magnetic resonance imaging data acquisition.

A clinical question to be answered may, e.g., be described by the target parameters defining the physiological target type of the magnetic resonance imaging data acquisition. Individual abilities of a patient may be defined by the physical parameters of the subject, i.e., the patient from which the magnetic resonance imaging data is to be acquired by the respective magnetic resonance imaging data acquisition. Relevant abilities of a patient may comprise an ability to hold breath and/or to lie still for an extended period of time. These abilities may depend on physical parameters of the subject provided by the third subset, like age, weight, and/or physical or mental impairments. Such physical parameters may, e.g., be acquired using suitable sensors, such an optical sensor, a weighing scale, or a sphygmomanometer. They may be provided for usage as a part of a definition dataset, e.g., using an electronic medical record (EMR).

In clinical practice, scan protocols in form of initial scan parameters may, e.g., be defined using standard procedures outlined by applicable guidelines and/or local preferences. In preparation of an exam, i.e., an MRI data acquisition, an exam-card comprising the initial scan parameters may be loaded and then adjusted to meet the exam and patient specific requirements. This may, e.g., also include planning an exact scan range based on localizer scans, but potentially also adjusting other initial scan parameters. Initial scan parameters may, e.g., be adjusted to shorten an overall scan time and/or to improve contrast in the clinically relevant tissue.

The quality of such adjustments is subject to the experience of the respective operator performing the exam. For the same purposes, e.g., for limiting the scan time, different strategies or scan parameter adjustments may be employed. Depending on the scanner, patient and potentially other factors, those strategies may result in different image qualities and consequently varying diagnostic values.

Providing an adjustment recommendation may help guiding a less experienced operator in order to improve the clinical value of the MRI data being acquired as well as of the resulting MRI images.

The adjustment recommendation may, e.g., comprise a single recommendation for adjusting at least some initial scan parameters of the first subset. For example, the adjustment recommendation may comprise a plurality of recommendations for adjusting at least some initial scan parameters of the first subset. The execution of the machine-executable instructions may, e.g., further cause the computational system to receive a selection of one of the recommendations to be used to adjust the at least some initial scan parameters of the first subset.

The adjustment recommendation may, e.g., recommend adjustments of a part of the initial scan parameters of the first subset. The adjustment recommendation may, e.g., recommend adjustments of all the initial scan parameters of the first subset.

For example, the memory further stores the plurality of reference datasets. The stored reference datasets are clustered using the initial reference scan parameters of the first reference subsets, the reference target parameters of the second reference subsets, and the physical reference parameters of the third reference subsets.

The providing of the adjustment recommendation may further comprise selecting by the recommendation module a cluster of reference datasets from the clustered plurality of reference datasets. Selection parameters used for the selecting comprise at least some of the following: the one or more initial scan parameters of the first subset, the one or more target parameters of the second subset, and the one or more physical parameters of the third subset.

The providing of the adjustment recommendation may further comprise extracting by the recommendation module one or more reference scan parameter adjustments comprised by one or more fourth reference subsets of the reference datasets of the selected cluster. The providing of the adjustment recommendation comprises using the extracted one or more reference scan parameter adjustments.

A database provided by the plurality of reference datasets may be clustered, i.e., the plurality of reference datasets may be provided as a clustered plurality of reference datasets. Besides the initial scan parameters, the clustering may also take into account the different exam types defined by the reference target parameters and patient characteristics defined by the physical reference parameters. Based on the initial scan parameters, e.g., provided by an initially selected exam-card, as well as the reference target parameters, reference datasets descriptive of similar exams may be identified by the clustering. Exams with similar profiles may be clustered, while also taking the patient characteristics into account using the physical reference parameters. The value of the data collection may then be leveraged, when setting up a new exam after the database, i.e., the clustered plurality of reference datasets, has been filled over a course of time. The respective database may be used for providing an adjustment recommendation for the initial scan parameters proposed for the new exam.

Expert's recommendations may also be taken into account, e.g., by a weighting of the reference scan parameter adjustments of the reference datasets by experts. This weighting may, e.g., comprise assigning weighting factors to the reference scan parameter adjustments. The extracting of the reference scan parameter adjustments may, e.g., depend on the weighting factors assigned to the reference scan parameter adjustments of the reference datasets of the selected cluster. For example, only reference scan parameter adjustments assigned with a weighting factor reaching a predefined threshold may be extracted. In case the extracted reference scan parameter adjustments are approximated, in order to determine scan parameter adjustments for the adjustment recommendations, the weighting factors may be used for a weighted approximation, e.g., determining of a weighted mean.

For example, the reference datasets may further be assigned with quality indicators. The quality indicators may, e.g., indicate a total scan time of the magnetic resonance imaging data acquisition using the reference initial scan parameters of the first reference subsets, which have been adjusted using the reference scan parameter adjustments of the fourth reference subsets. The quality indicators may, e.g., indicate a signal-to-noise ratio of reference magnetic resonance imaging data acquired using the reference initial scan parameters of the first reference subsets, which have been adjusted using the reference scan parameter adjustments of the fourth reference subsets. The quality indicators may, e.g., indicate a spatial resolution of reference magnetic resonance imaging data acquired using the reference initial scan parameters of the first reference subsets, which have been adjusted using the reference scan parameter adjustments of the fourth reference subsets. For determining the quality indicators, the reference datasets, at least the reference datasets describing actual MRI data acquisitions, may, e.g., further comprise fifth reference subsets. The fifth reference subsets may comprise reference magnetic resonance imaging data acquired using the reference initial scan parameters of the first reference subsets, which have been adjusted using the reference scan parameter adjustments of the fourth reference subsets. This reference magnetic resonance imaging data may be used for determining at least some of the quality indicators, e.g., quality indicators indicating a signal-to-noise ratio and/or indicators indicating a spatial resolution of the respective reference magnetic resonance imaging data.

For example, the plurality of reference datasets may only comprise reference datasets satisfying a certain quality requirement. The quality requirement may comprise, e.g., a maximum scan time, a minimum signal-to-noise ratio, and/or a minimum spatial resolution. Using the quality indicators assigned to the reference datasets a pre-selection may be executed to delete from the plurality of reference datasets and/or to prevent from being added to the plurality of reference datasets such reference datasets with quality indicators not satisfying the quality requirement. Thus, it may be ensured that all the reference datasets used for determining the adjustment recommendation satisfy the quality requirement, i.e., enable an MRI data acquisition of a certain quality level.

For example, the reference datasets may comprise reference datasets on specific exam use cases, such as implants and propose scan parameter adaptions to meet image quality requirements and/or patient safety requirements. Implants may be taken into account in form of the physical reference parameters, which may be descriptive, e.g., of implants of the subject.

The extraction of the reference scan parameter adjustments from reference datasets of the selected cluster may, e.g., comprise a pre-selection by the recommendation module using quality indicators and/or effect indicators assigned to the reference datasets. The recommendation module may, e.g., be configured to select for the extraction scan parameter adjustments of one or more reference datasets assigned with quality indicators and/or effect indicators indicating a highest level of quality or a highest level of effect resulting from using the respective scan parameter adjustments. A highest level of quality and/or effect may refer to a highest level compared to qualities and/or effects assigned to other reference datasets of the cluster in form of quality indicators and/or effect indicators. Quality may, e.g., be determined in terms of total scan time, signal-to-noise ratio, and/or spatial resolution. The smaller the scan time, the higher the signal-to-noise ratio, and/or the higher spatial resolution, the higher the quality level may be. The effect may, e.g., be determined in terms of reduction of the total scan time, increase of signal-to-noise ratio, and/or increase of spatial resolution. The larger the reduction in scan time, the lager the increase of the signal-to-noise ratio, and/or the larger the increase of the spatial resolution, the better the resulting effect may be.

The extraction of the reference scan parameter adjustments from reference datasets of the selected cluster may, e.g., further comprise a check, whether a contrast characteristic of the acquired MRI data changes due to scan parameter adjustments of reference datasets of the selected cluster. When changing MRI scan parameters, the measured contrast characteristics, e.g., T1-weighted, T2-weigted, or proton density, may be changed involuntarily. For example, the recommendation module may be configured to check, whether initial reference scan parameters adjusted using the reference scan parameter adjustments defined by the same reference dataset result in scan parameters, which match a scan series description comprised by the definition dataset. For example, the reference datasets may comprise scan series description of the scan series resulting from applying the reference scan parameter adjustments.

For example, the recommendation module may be configured to provide in addition to the adjustment recommendation an indicator indicating a change of the measured contrast characteristics, in case the adjustment recommendation determines that the extracted reference scan parameter adjustments result in scan parameters, which do not match a scan series description comprised by the definition dataset. The recommendation module may, e.g., use a scan series description of the reference dataset, from which the reference scan parameter adjustments are extracted. The respective scan series description may describe a scan series resulting from applying the reference scan parameter adjustments.

Reference scan parameter adjustments, which result in a change of the measured contrast characteristics, may, e.g., be prevented from being extracted for providing the adjustment recommendation. Thus, changes of the measured contrast characteristics, when applying the adjustment recommendation, may be avoided.

For example, all the reference datasets are descriptive of reference magnetic resonance imaging data acquisitions executed using the same type of MRI system.

For example, the provided adjustment recommendation comprises one or more of the extracted one or more reference scan parameter adjustments. For example, extracted reference scan parameter adjustments may be used as the adjustment recommendation. The extracted reference scan parameters may be reference scan parameters extracted from a single reference dataset of the selected cluster of reference datasets. The respective reference dataset may, e.g., be a reference dataset with parameters best matching the parameters of the definition dataset. For example, a reference dataset of the selected cluster may be identified with initial reference scan parameters, reference target parameters, and physical reference parameters best matching the initial scan parameters, target parameters, and physical parameters of the definition dataset. Best matching refers to comprising the smallest deviations from the respective parameters of the definition dataset. For example, the initial reference scan parameters, reference target parameters, and physical reference parameters of the identified reference dataset may be identical to the initial scan parameters, target parameters, and physical parameters of the definition dataset. For example, the reference scan parameter adjustments of the identified reference datasets may be extracted and used for providing the adjustment recommendation.

The respective reference dataset may, e.g., be a reference dataset assigned with quality indicators and/or effect indicators indicating a highest quality and/or a largest effect resulting from the reference scan parameter adjustments of the respective reference dataset compared to the other reference datasets comprised by the selected cluster.

For example, the providing of the adjustment recommendation further comprises determining one or more approximated reference scan parameter adjustments using the extracted reference scan parameter adjustments. The provided adjustment recommendation comprises the determined one or more approximated reference scan parameter adjustments.

The one or more approximated reference scan parameter adjustments may, e.g., be determined using a mean, e.g., a weighted mean, a median, a mode, or a mid-range of the extracted reference scan parameter adjustments. A mean may, e.g., be an arithmetic mean, i.e., a sum of values of a set of values divided by the number of values. A median refers to a middle value separating a greater and lesser half of a set of values. A mode referes to a value occuring most frequently in a set of values. A mid-range refers to an arithmetic mean of a highest and lowest values of a set of values.

The reference scan parameter adjustments may be extracted from a plurality of reference datasets comprised by the selected cluster. The respective reference datasets, from which the reference scan parameter adjustments are extracted, may, e.g., be reference datasets with parameters best matching the parameters of the definition dataset. For example, the provided adjustment recommendation may comprise the determined approximated reference scan parameter adjustments. For example, a plurality of reference datasets of the selected cluster may be identified with deviations of their initial reference scan parameters, reference target parameters, and physical reference parameters from the initial scan parameters, target parameters, and physical parameters of the definition dataset, respectively, reaching predefined thresholds. For example, the deviations or a combination of the deviations may be smaller than predefined thresholds for the respective deviations or a predefined thresholds for the respective combination. For example, all the reference datasets of the selected cluster may be identified. For example, the reference scan parameter adjustments of the identified plurality of reference datasets of the selected cluster may be extracted and approximated to provide the approximated, i.e., mean, reference scan parameter adjustments. These approximated reference scan parameter adjustments may be used for providing the adjustment recommendation.

The respective reference datasets, from which the reference scan parameter adjustments are extracted, may, e.g., be reference datasets assigned with quality indicators and/or effect indicators indicating a highest quality and/or a largest effect resulting from the reference scan parameter adjustments of the respective reference datasets compared to the other reference datasets comprised by the selected cluster.

For example, the execution of the machine-executable instructions further causes the computational system to provide the stored clustered plurality of reference datasets. The providing of the stored clustered plurality of reference datasets comprises receiving the plurality of reference datasets, clustering the plurality of reference datasets, storing the resulting clustered plurality of reference datasets. Before clustering, e.g., reference datasets of an insufficient quality may, e.g., be sorted out using quality indicators and/or effect indicators assigned to the received reference datasets. Thus, reference datasets with quality indicators and/or effect indicators indication an insufficient quality or effect, respectively, resulting from the reference scan parameter adjustments of the respective reference datasets may be neglected when executing the clustering.

For example, the providing of the adjustment recommendation further comprises providing one or more effect indicators indicating one or more effects of the recommended adjustment of the at least some initial scan parameters of the first subset on the magnetic resonance imaging data acquisition to be executed.

Example, by using effect indicators, may allow to corelate the adjustment recommendation with its outcome, i.e., effect. For example, the adjusting of the initial scan parameters may result in a reduction of a total scan time. For example, the adjusting of the initial scan parameters may result in an improved of image quality. The improvement of image quality may, e.g., comprise an increase in signal-to-noise ratio and/or in an increase of a spatial resolution of the MRI data acquired.

For example, the one or more effect indicators indicate an effect of the recommended adjustment on a scan time of the magnetic resonance imaging data acquisition to be executed.

For example, the effect indicator may indicate that the was reduced by x second due to the applying the reference scan parameter adjustments, based on which the adjustment recommendation is provided.

For example, the effect of the recommended adjustment on the scan time is determined using a comparison of the at least some initial scan parameters with and without the adjustments according to the adjustment recommendation.

The effect of the recommended adjustment on the scan time may be deterministic, i.e., a first scan time required to execute scans according to the initial scan parameters without the adjustments according to the adjustment recommendation may be determined and a second scan time required to execute scans according to the initial scan parameters with the adjustments according to the adjustment recommendation may be determined. The first and second scan time may be compared, in order to determine the effect of the recommended adjustment on the scan time of the magnetic resonance imaging data acquisition to be executed.

For example, the one or more effect indicators indicate an effect of the recommended adjustment on magnetic resonance imaging data acquired by the acquisition to be executed regarding one or more of the following parameters: a signal-to-noise ratio, a spatial resolution.

For example, the reference datasets further comprise fifth reference subsets comprising reference magnetic resonance imaging data acquired using the reference initial scan parameters of the first reference subsets, which have been adjusted using the reference scan parameter adjustments of the fourth reference subsets.

The execution of the machine-executable instructions further causes the computational system to receive a plurality of assessment datasets of a plurality of magnetic resonance imaging data acquisitions. Each of the assessment datasets comprises a first assessment subset with one or more assessment scan parameters used for executing the respective magnetic resonance imaging data acquisition. Each of the assessment datasets further comprises a second assessment subset with one or more assessment target parameters defining a physiological target type of the respective magnetic resonance imaging data acquisition. Each of the assessment datasets further comprises a third assessment subset with one or more physical assessment parameters of a subject, from which magnetic resonance imaging data is acquired by the respective magnetic resonance imaging data acquisition. Each of the assessment datasets further comprises a fourth assessment subset with assessment magnetic resonance imaging data acquired using the assessment scan parameters of the first assessment subsets.

The one or more assessment scan parameters of the first assessment subset may, e.g., comprise one or more assessment scan parameters defining one or more of the following features of the assessment MRI data acquisition: one or more Times to Echo (TE); one or more Repetition Times (TR); one or more flip angles; one or more Inversion Times (TI); a number of acquisitions, i.e., a number of averages used; one or more scan geometry matrices; one or more slice dimensions. The one or more assessment target parameters of the second assessment subset may, e.g., comprise one or more assessment target parameters defining one or more of the following features of a physiological target type of the assessment MRI data acquisition: one or more internal organs, such as liver, kidney, heart, brain, etc., and/or one or more sections of the one or more internal organs; a clinical indication, such as a morphological state, an oncological state and/or a functional state, such as a cardiac function, of the respective internal organ, to be determined using the assessment MRI data acquisition. The one or more physical assessment parameters of the third assessment subset may, e.g., comprise one or more physical parameters defining one or more of the following features of the subject of the assessment MRI data acquisition: one or more general physical features of a subject, such as age, sex, weight, height; one or more physical abilities, such as an ability to hold breath; one or more features of physical constitution of the subject, such as a tremor, a low or high blood pressure, etc.

The execution of the machine-executable instructions further causes the computational system to identifying for the one or more reference datasets of the selected cluster of reference datasets, from which reference scan parameter adjustments are extracted, one or more corresponding assessment datasets with first assessment subset matching the respective first reference subsets, with second assessment subsets matching the respective second reference subsets, and with third assessment subsets matching the respective third reference subsets.

The execution of the machine-executable instructions further causes the computational system to using a comparison of the assessment magnetic resonance imaging data of the fourth assessment subsets of the identified one or more corresponding assessment datasets with the reference magnetic resonance imaging data of the fifth reference subsets of the one or more reference datasets of the selected cluster of reference datasets, from which reference scan parameter adjustments are extracted, for determining the effect of the recommended adjustment on magnetic resonance imaging data acquired by the acquisition to be executed.

Using the assessment datasets, the effects of the reference scan parameter adjustments and, thus, of the adjustment recommendation provided using the reference scan parameter adjustments may be determined. For example, the effect of the adjustment recommendation on image quality may be assessed. Image quality may be quantified, e.g., in terms of signal-to-noise ratio and/or in terms of spatial resolution.

Here, matching may, e.g., refer to best matching the initial scan parameters, target parameters, and physical parameters of the definition dataset. Best matching refers to comprising the smallest deviations from the respective parameters of the respective reference dataset. For example, the assessment scan parameters, assessment target parameters, and physical assessment parameters may be identical to the initial reference scan parameters, reference target parameters, and physical reference parameters of the respective reference dataset.

The identifying of the corresponding assessment datasets and the determining of the effects of the recommended adjustment regarding the signal-to-noise ratio and/or regarding the spatial resolution may, e.g., be executed by the recommendation module. The recommendation module may, e.g., further be configured, in response to receiving the definition dataset defining a magnetic resonance imaging data acquisition to be executed, to output the one or more indicators indicating the effect of the recommended adjustment on the signal-to-noise ratio and/ the spatial resolution of magnetic resonance imaging data acquired by the acquisition to be executed.

The identifying of the corresponding assessment datasets and the determining of the effects of the recommended adjustment regarding the signal-to-noise ratio and/or regarding the spatial resolution may, e.g., be executed by an additional assessment module stored in the memory of the medical system. The assessment module may, e.g., be configured, in response to receiving the extracted reference scan parameter adjustments as well as the fifth reference subsets of the reference datasets of the selected cluster of reference datasets, from which reference scan parameter adjustments are extracted, to output the one or more effect indicators indicating the effect of the recommended adjustment on the signal-to-noise ratio and/ the spatial resolution of magnetic resonance imaging data acquired by the acquisition to be executed.

For example, all the assessment datasets are descriptive of magnetic resonance imaging data acquisitions executed using the same type of MRI system.

For example, a machine learning module may be provided, which is trained to output one or more quality indicators in response to receiving a reference dataset or at least a fifth reference subset of the reference dataset, which comprises magnetic resonance imaging data acquired using the reference initial scan parameters of the first reference subsets adjusted using the reference scan parameter adjustments of the fourth reference subsets of the respective reference dataset. The quality indicators may indicate a quality of the reference magnetic resonance imaging data of the respective reference dataset.

The machine learning module may, e.g., comprise a support vector machine, a decision tree learning module, a recommender system, and/or a neural network, like a Convolutional Neural Network (CNN). A support vector machine refers to a supervised max-margin model with associated learning algorithm, which is configured to analyze data for classification and regression analysis. A decision tree learning module refers to a module using a supervised learning approach with a classification or regression decision tree being used as a predictive model to draw conclusions about a set of observations. A recommender system refers to an information filtering system configured for providing a recommendation most pertinent to a particular user. Implemented as a machine learning module, it may, e.g., use collaborative filtering, such as K-nearest neighbors, or a neural network, e.g., a CNN. A CNN refers to a regularized type of feed-forward neural network, which is configured to learn feature engineering by itself via filters optimization.

The machine learning module may, e.g., be trained using training datasets. Each of the training datasets may, e.g., comprises training magnetic resonance imaging data and one or more training quality indicators indicative of a quality of the respective training magnetic resonance imaging data. The machine learning module may be trained using the training datasets to output the one or more training quality indicators in response to receiving the training magnetic resonance imaging data of the respective training datasets as an input.

For example, the recommendation module comprises a machine learning module trained, using the plurality of reference datasets, to output the adjustment recommendation in response to receiving the definition dataset.

The machine learning module may, e.g., comprise a support vector machine, a decision tree learning module, a recommender system, and/or a neural network, like a CNN.

For example, the execution of the machine-executable instructions further causes the computational system to provide the trained machine learning module. The providing of the trained machine learning module comprises receiving the plurality of reference datasets as training datasets for training the machine learning module.

The providing of the trained machine learning module further comprises training the machine learning module to output the one or more reference scan parameter adjustments of the fourth reference subsets of the reference datasets as adjustment recommendations for an adjustment of at least some of the one or more initial training scan parameters of the first reference subsets of the respective reference datasets in response to receiving the first, second and third reference subsets of the respective reference datasets.

The training datasets may, e.g., be provided using the aforementioned reference datasets.

For example, the machine learning module of the recommendation module may further be trained to output in addition to the adjustment recommendation a quality indicator and/or an effect indicator. The quality indicator may indicate a quality of the magnetic resonance imaging data acquisition resulting, when applying the adjustment recommendation. The quality may, e.g., be described in terms of total scan time, signal-to-noise ratio and/or spatial resolution. The effect indicator may indicate an effect of applying the adjustment recommendation to the initial scan parameters. The effect may be described in terms of changes of the total scan time, the signal-to-noise ratio and/or the spatial resolution, due to the application of the adjustment recommendation.

For training the machine learning module of the recommendation module to additionally output a quality indicator, the reference datasets used as training datasets may further comprise training quality indicators indicating a quality of the magnetic resonance imaging data acquired or acquirable by using the initial reference scan parameters adjusted using the reference scan parameter adjustments of the respective reference datasets.

For training the machine learning module of the recommendation module to additionally output a quality indicator, the reference datasets used as training datasets may further comprise training effect indicators indicating an effect of applying the reference scan parameter adjustments to the initial reference scan parameters of the respective reference datasets.

For example, all the training datasets are descriptive of training magnetic resonance imaging data acquisitions executed using the same type of MRI system.

For example, the medical system further comprises a magnetic resonance imaging system. The execution of the machine-executable instructions further causes the computational system to acquire magnetic resonance imaging data using the adjusted at least some initial scan parameters of the first subset.

For example, the adjustment recommendation may be provided on a scanner console of the resonance imaging system, i.e., the medical system may comprise the respective scanner console. For example, the adjustment recommendation may be provided on a separate operator interface provided by the medical system.

In another example, a computer program comprises machine-executable instructions and a recommendation module. The recommendation module is configured, using a plurality of reference datasets of a plurality of reference magnetic resonance imaging data acquisitions, to output an adjustment recommendation for an adjustment of at least some initial scan parameters of a first subset of a definition dataset. The definition dataset defines a magnetic resonance imaging data acquisition to be executed. The recommendation module is configured to output the adjustment recommendation in response to receiving the definition dataset as input.

The definition dataset comprises the first subset with one or more initial scan parameters proposed for the magnetic resonance imaging data acquisition, a second subset with one or more target parameters defining a physiological target type of the magnetic resonance imaging data acquisition, and a third subset with one or more physical parameters of a subject, from which magnetic resonance imaging data is to be acquired by the respective magnetic resonance imaging data acquisition.

Each of the reference datasets comprises a first reference subset with one or more initial reference scan parameters proposed for the respective reference magnetic resonance imaging data acquisition, a second reference subset with one or more reference target parameters defining a physiological target type of the respective reference magnetic resonance imaging data acquisition, a third reference subset with one or more physical reference parameters of a subject, from which magnetic resonance imaging data is acquired by the respective reference magnetic resonance imaging data acquisition, and a fourth reference subset with one or more reference scan parameter adjustments applied to the initial reference scan parameters of the respective reference magnetic resonance imaging data acquisition.

The machine-executable instructions are configured for causing a computational system to receive the definition dataset. The machine-executable instructions are further configured for causing the computational system to provide the adjustment recommendation using the definition dataset and the recommendation module. The machine-executable instructions are further configured for causing the computational system to adjust the at least some initial scan parameters of the first subset using the adjustment recommendation.

The machine-executable instructions comprised by the computer program may, e.g., be configured for controlling any of the examples of a medical system described herein.

In another example, a method for controlling a medical system is provided. The medical system comprises a memory storing machine-executable instructions and a recommendation module. The recommendation module is configured, using a plurality of reference datasets of a plurality of reference magnetic resonance imaging data acquisitions, to output an adjustment recommendation for an adjustment of at least some initial scan parameters of a first subset of a definition dataset. The definition dataset defines a magnetic resonance imaging data acquisition to be executed. The recommendation module is configured to output the adjustment recommendation in response to receiving the definition dataset as input.

The definition dataset comprises the first subset with one or more initial scan parameters proposed for the magnetic resonance imaging data acquisition, a second subset with one or more target parameters defining a physiological target type of the magnetic resonance imaging data acquisition, and a third subset with one or more physical parameters of a subject, from which magnetic resonance imaging data is to be acquired by the respective magnetic resonance imaging data acquisition.

Each of the reference datasets comprises a first reference subset with one or more initial reference scan parameters proposed for the respective reference magnetic resonance imaging data acquisition, a second reference subset with one or more reference target parameters defining a physiological target type of the respective reference magnetic resonance imaging data acquisition, a third reference subset with one or more physical reference parameters of a subject, from which magnetic resonance imaging data is acquired by the respective reference magnetic resonance imaging data acquisition, and a fourth reference subset with one or more reference scan parameter adjustments applied to the initial reference scan parameters of the respective reference magnetic resonance imaging data acquisition.

The medical system further comprises a computational system.

An execution of the machine-executable instructions causes the computational system to execute the method comprising receiving the definition dataset. The method further comprising providing the adjustment recommendation using the definition dataset and the recommendation module. The method further comprising adjusting the at least some initial scan parameters of the first subset using the adjustment recommendation.

The method may, e.g., be configured for controlling any of the examples of a medical system described herein.

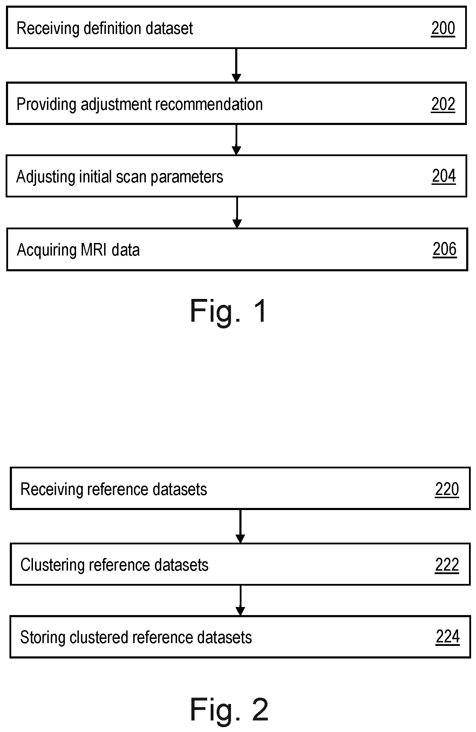

Fig. 1 illustrates an exemplary method for providing an adjustment recommendation for adjusting initial scan parameters. For executing the method, a medical system may be used. Thus, the method may be a method for controlling the medical system. The medical system may comprise a memory storing machine-executable instructions and a recommendation module. The recommendation module may be configured, using a plurality of reference datasets of a plurality of reference magnetic resonance imaging data acquisitions, to output an adjustment recommendation for an adjustment of at least some initial scan parameters of a first subset of a definition dataset. The definition dataset defines a magnetic resonance imaging data acquisition to be executed. The recommendation module is configured to output the adjustment recommendation in response to receiving the definition dataset as input.

Each of the reference datasets comprises a first reference subset with one or more initial reference scan parameters proposed for the respective reference magnetic resonance imaging data acquisition, a second reference subset with one or more reference target parameters defining a physiological target type of the respective reference magnetic resonance imaging data acquisition, a third reference subset with one or more physical reference parameters of a subject, from which magnetic resonance imaging data is acquired by the respective reference magnetic resonance imaging data acquisition, and a fourth reference subset with one or more reference scan parameter adjustments applied to the initial reference scan parameters of the respective reference magnetic resonance imaging data acquisition.

An execution of the machine-executable instructions may cause the computational system to execute the method.

In block 200, the definition dataset is received. The definition dataset may comprise the first subset with one or more initial scan parameters proposed for the magnetic resonance imaging data acquisition, a second subset with one or more target parameters defining a physiological target type of the magnetic resonance imaging data acquisition, and a third subset with one or more physical parameters of a subject, from which magnetic resonance imaging data is to be acquired by the respective magnetic resonance imaging data acquisition. Furthermore, the medical system may comprise a computational system.

In block 202, the adjustment recommendation is provided using the definition dataset and the recommendation module. The adjustment recommendation may recommend an adjustment of some or all the initial scan parameters of the first subset. Providing the adjustment recommendation may comprise providing the definition dataset as input to the recommendation module. In response to receiving the definition dataset as input, the recommendation module may output the adjustment recommendation.

For example, the memory may further store the plurality of reference datasets. The stored plurality reference datasets may be stored in form of a clustered plurality of reference datasets. The stored reference datasets may be clustered using the initial reference scan parameters of the first reference subsets, the reference target parameters of the second reference subsets, and the physical reference parameters of the third reference subsets. Thus, reference datasets with highly similar and/or identical initial reference scan parameters, the reference target parameters, and the physical reference parameters may be assigned to the same cluster.

The providing of the adjustment recommendation in block 202 may further comprise selecting by the recommendation module a cluster of reference datasets from the clustered plurality of reference datasets using selection parameters. The selection parameters used for selecting the cluster may, e.g., comprise at least some of the following: the one or more initial scan parameters of the first subset, the one or more target parameters of the second subset, and the one or more physical parameters of the third subset. For example, all the initial scan parameters, target parameters, and physical parameters may be used for selecting the cluster. For example, the selected cluster may be the cluster, to which the definition dataset would be assigned, if it was taken into account for the clustering. Thus, the selected cluster may be a cluster with reference datasets that comprise initial reference scan parameters, the reference target parameters, and the physical reference parameters highly similar and/or identical to the initial scan parameters, target parameters, and physical parameters of the definition dataset.

The providing of the adjustment recommendation in block 202 may further comprise extracting by the recommendation module one or more reference scan parameter adjustments comprised by one or more fourth reference subsets of the reference datasets of the selected cluster and using the extracted one or more reference scan parameter adjustments for providing of the adjustment recommendation.

For example, the provided adjustment recommendation may comprise the extracted reference scan parameter adjustments, i.e., the extracted reference scan parameter adjustments may be used as the adjustment recommendation. For example, a reference dataset of the selected cluster may be identified with initial reference scan parameters, reference target parameters, and physical reference parameters best matching the initial scan parameters, target parameters, and physical parameters of the definition dataset. Best matching refers to comprising the smallest deviations from the respective parameters of the definition dataset. For example, the initial reference scan parameters, reference target parameters, and physical reference parameters of the identified reference dataset may be identical to the initial scan parameters, target parameters, and physical parameters of the definition dataset. For example, the reference scan parameter adjustments of the identified reference datasets may be extracted and used for providing the adjustment recommendation.

The respective reference dataset may, e.g., be a reference dataset assigned with quality indicators and/or effect indicators indicating a highest quality and/or a largest effect resulting from the reference scan parameter adjustments of the respective reference dataset compared to the other reference datasets comprised by the selected cluster.

For example, the providing of the adjustment recommendation in block 202 may comprise determining by the recommendation module one or more approximated reference scan parameter adjustments using the extracted reference scan parameter adjustments. For example, the provided adjustment recommendation may comprise the determined approximated reference scan parameter adjustments. The one or more approximated reference scan parameter adjustments may, e.g., be determined using a mean, e.g., a weighted mean, a median, a mode, or a mid-range of the extracted reference scan parameter adjustments.

For example, a plurality of reference datasets of the selected cluster may be identified with deviations of their initial reference scan parameters, reference target parameters, and physical reference parameters from the initial scan parameters, target parameters, and physical parameters of the definition dataset, respectively, reaching predefined thresholds. For example, the deviations or a combination of the deviations may be smaller than predefined thresholds for the respective deviations or a predefined thresholds for the respective combination. For example, all the reference datasets of the selected cluster may be identified. For example, the reference scan parameter adjustments of the identified plurality of reference datasets of the selected cluster may be extracted and approximated to provide the approximated, i.e., mean, reference scan parameter adjustments. These approximated reference scan parameter adjustments may be used for providing the adjustment recommendation.

The respective reference datasets, from which the reference scan parameter adjustments are extracted, may, e.g., be reference datasets assigned with quality indicators and/or effect indicators indicating a highest quality and/or a largest effect resulting from the reference scan parameter adjustments of the respective reference datasets compared to the other reference datasets comprised by the selected cluster.

The execution of the machine-executable instructions further causes the computational system to provide the stored clustered plurality of reference datasets for usage in block 202. The providing of the stored clustered plurality of reference datasets may, e.g., comprise receiving the plurality of reference datasets, clustering the plurality of reference datasets, and storing the resulting clustered plurality of reference datasets. The received plurality of reference datasets may, e.g., be clustered using the initial reference scan parameters of the first reference subsets, the reference target parameters of the second reference subsets, and the physical reference parameters of the third reference subsets as parameters for the clustering. Thus, reference datasets with highly similar and/or identical initial reference scan parameters, the reference target parameters, and the physical reference parameters may be assigned to the same cluster.

In addition to the providing of the adjustment recommendation, in block 202, e.g., furthermore one or more effect indicators indicating one or more effects of the recommended adjustment on the magnetic resonance imaging data acquisition to be executed may be provided.

The one or more effect indicators may, e.g., indicate an effect of the recommended adjustment on a scan time of the magnetic resonance imaging data acquisition to be executed. The recommended adjustment may, e.g., result in a shortening of the scan time. The effect of the recommended adjustment on the scan time is, e.g., determined using a comparison of the at least some initial scan parameters with and without the adjustments according to the adjustment recommendation. The effect of the recommended adjustment on the scan time may be deterministic, i.e., a first scan time required to execute scans according to the initial scan parameters without the adjustments according to the adjustment recommendation may be determined and a second scan time required to execute scans according to the initial scan parameters with the adjustments according to the adjustment recommendation may be determined. The first and second scan time may be compared, in order to determine the effect of the recommended adjustment on the scan time of the magnetic resonance imaging data acquisition to be executed.

The one or more effect indicators may, e.g., indicate an effect of the recommended adjustment on magnetic resonance imaging data acquired by the acquisition to be executed regarding a signal-to-noise ratio and/or a spatial resolution.

For example, the reference datasets of the clustered plurality of reference datasets may further comprise fifth reference subsets. The fifth reference subsets may comprise reference magnetic resonance imaging data acquired using the reference initial scan parameters of the first reference subsets of the respective reference datasets, which have been adjusted using the reference scan parameter adjustments of the fourth reference subsets.

The execution of the machine-executable instructions may further cause the computational system to receive a plurality of assessment datasets of a plurality of magnetic resonance imaging data acquisitions. These assessment datasets may be used to determine effects of the recommended adjustment regarding a signal-to-noise ratio and/or regarding a spatial resolution of magnetic resonance imaging data acquired by the acquisition to be executed.

Each of the assessment datasets may comprise a first assessment subset with one or more assessment scan parameters used for executing the respective magnetic resonance imaging data acquisition, a second assessment subset with one or more assessment target parameters defining a physiological target type of the respective magnetic resonance imaging data acquisition, a third assessment subset with one or more physical assessment parameters of a subject, from which magnetic resonance imaging data is acquired by the respective magnetic resonance imaging data acquisition, and a fourth assessment subset with assessment magnetic resonance imaging data acquired using the assessment scan parameters of the first assessment subsets.

The execution of the machine-executable instructions may further cause the computational system to identify for the one or more reference datasets of the selected cluster of reference datasets, from which reference scan parameter adjustments are extracted, one or more corresponding assessment datasets with first assessment subset matching the respective first reference subsets, with second assessment subsets matching the respective second reference subsets, and with third assessment subsets matching the respective third reference subsets.

Here, matching may, e.g., refer to best matching the initial scan parameters, target parameters, and physical parameters of the definition dataset. Best matching refers to comprising the smallest deviations from the respective parameters of the respective reference dataset. For example, the assessment scan parameters, assessment target parameters, and physical assessment parameters may be identical to the initial reference scan parameters, reference target parameters, and physical reference parameters of the respective reference dataset.

The execution of the machine-executable instructions may further cause the computational system to determine the effects of the recommended adjustment regarding the signal-to-noise ratio and/or regarding the spatial resolution of magnetic resonance imaging data acquired by the acquisition to be executed. For this purpose, a comparison of the assessment magnetic resonance imaging data of the fourth assessment subsets of the identified assessment datasets with the reference magnetic resonance imaging data of the fifth reference subsets of the reference datasets of the selected cluster of reference datasets, from which reference scan parameter adjustments are extracted, may be used.

For example, a first signal-to-noise ratio of the assessment magnetic resonance imaging data and a second signal-to-noise ratio of the reference magnetic resonance imaging data may be determined. The first and second signal-to-noise ratio may be compared to determine the effect of the recommended adjustment on the signal-to-noise ratio of magnetic resonance imaging data acquired by the acquisition to be executed. The first signal-to-noise ratio may provide an estimate of the signal-to-noise ratio, in case the recommended adjustment is not applied, while the second signal-to-noise ratio may provide an estimate of the signal-to-noise ratio, in case the recommended adjustment is applied.

For example, a first spatial resolution of the assessment magnetic resonance imaging data and a second spatial resolution of the reference magnetic resonance imaging data may be determined. The first and second spatial resolution may be compared to determine the effect of the recommended adjustment on the spatial resolution of magnetic resonance imaging data acquired by the acquisition to be executed. The first spatial resolution may provide an estimate of the spatial resolution, in case the recommended adjustment is not applied, while the second spatial resolution may provide an estimate of the spatial resolution, in case the recommended adjustment is applied.

The identifying of the corresponding assessment datasets and the determining of the effects of the recommended adjustment regarding the signal-to-noise ratio and/or regarding the spatial resolution may, e.g., be executed by the recommendation module. The recommendation module may, e.g., further be configured, in response to receiving the definition dataset defining a magnetic resonance imaging data acquisition to be executed, to output the one or more effect indicators indicating the effect of the recommended adjustment on the signal-to-noise ratio and/ the spatial resolution of magnetic resonance imaging data acquired by the acquisition to be executed.

The identifying of the corresponding assessment datasets and the determining of the effects of the recommended adjustment regarding the signal-to-noise ratio and/or regarding the spatial resolution may, e.g., be executed by an additional assessment module stored in the memory of the medical system. The assessment module may, e.g., be configured, in response to receiving the extracted reference scan parameter adjustments as well as the fifth reference subsets of the reference datasets of the selected cluster of reference datasets, from which reference scan parameter adjustments are extracted, to output the one or more effect indicators indicating the effect of the recommended adjustment on the signal-to-noise ratio and/ the spatial resolution of magnetic resonance imaging data acquired by the acquisition to be executed.

Alternatively to providing a clustered plurality of reference datasets, e.g., stored in the memory of the medical system, the recommendation module may, e.g., comprise a machine learning module trained, using the plurality of reference datasets, to output the adjustment recommendation in response to receiving the definition dataset.

In block 204, the at least some initial scan parameters of the first subset are adjusted using the adjustment recommendation.

In case the medical system further comprises a magnetic resonance imaging system, execution of the machine-executable instructions further causes the computational system in block 206 to acquire magnetic resonance imaging data using the adjusted at least some initial scan parameters of the first subset. In addition, the also further non-adjusted initial scan parameters, if comprised by the first subset, may be used to acquire the magnetic resonance imaging data. Alternatively, the definition dataset with the adjusted first subset or at least the first subset may be sent to a further magnetic resonance imaging system for usage to acquire magnetic resonance data. The further magnetic resonance imaging system may be cause in in block 206 to acquire magnetic resonance imaging data using the adjusted at least some initial scan parameters of the first subset, which have been received as part of the definition dataset or at least as part of the first subset. In addition, the also further non-adjusted initial scan parameters, if comprised by the first subset, may be used to acquire the magnetic resonance imaging data.

Fig. 2 illustrates an exemplary method for providing a clustered plurality of reference datasets, e.g., stored in a memory of a medical system used for providing an adjustment recommendation for adjusting initial scan parameters. The provided plurality of reference datasets may, e.g., be used in block 202 of Fig. 1 for providing the adjustment recommendation. An execution of machine-executable instructions stored in the memory of the medical system may cause a computational system of the medical system to execute the method.

In block 220, a plurality of reference datasets may be received. Each of the received reference datasets may comprise a first reference subset with one or more initial reference scan parameters proposed for the respective reference magnetic resonance imaging data acquisition, a second reference subset with one or more reference target parameters defining a physiological target type of the respective reference magnetic resonance imaging data acquisition, a third reference subset with one or more physical reference parameters of a subject, from which magnetic resonance imaging data is acquired by the respective reference magnetic resonance imaging data acquisition, and a fourth reference subset with one or more reference scan parameter adjustments applied to the initial reference scan parameters of the respective reference magnetic resonance imaging data acquisition.

In block 222, the received reference datasets of the plurality of reference datasets are clustered. The received reference datasets may, e.g., be clustered using the initial reference scan parameters of the first reference subsets, the reference target parameters of the second reference subsets, and the physical reference parameters of the third reference subsets as parameters for the clustering. Thus, reference datasets with highly similar and/or identical initial reference scan parameters, the reference target parameters, and the physical reference parameters may be assigned to the same cluster.

In block 224, the clustered plurality of reference datasets resulting from block 222 is stored.

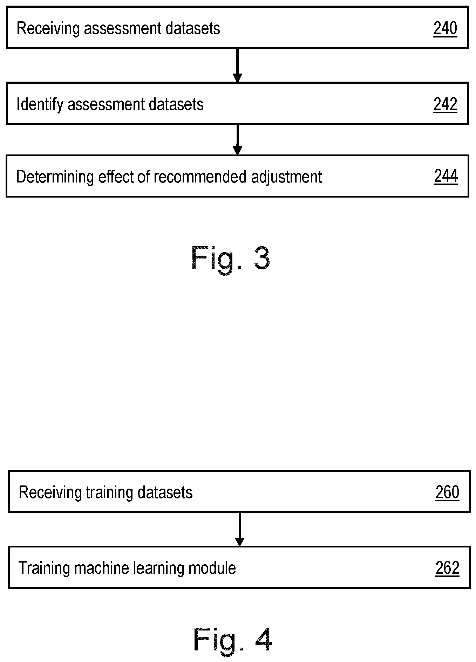

Fig. 3 illustrates an exemplary method for determining one or more effect indicators indicating an effect of the recommended adjustment, e.g., the recommended adjustment of block 202 of Fig. 1, on magnetic resonance imaging data acquired by the acquisition to be executed regarding a signal-to-noise ratio and/or a spatial resolution. For example, reference datasets of the clustered plurality of reference datasets used for determining the recommended adjustment may further comprise fifth reference subsets. The fifth reference subsets may comprise reference magnetic resonance imaging data acquired using the reference initial scan parameters of the first reference subsets of the respective reference datasets, which have been adjusted using the reference scan parameter adjustments of the fourth reference subsets. An execution of machine-executable instructions stored in the memory of the medical system may cause a computational system of the medical system to execute the method.

In block 240, a plurality of assessment datasets of a plurality of magnetic resonance imaging data acquisitions is received. Each of the received assessment datasets may comprise a first assessment subset with one or more assessment scan parameters used for executing the respective magnetic resonance imaging data acquisition, a second assessment subset with one or more assessment target parameters defining a physiological target type of the respective magnetic resonance imaging data acquisition, a third assessment subset with one or more physical assessment parameters of a subject, from which magnetic resonance imaging data is acquired by the respective magnetic resonance imaging data acquisition, and a fourth assessment subset with assessment magnetic resonance imaging data acquired using the assessment scan parameters of the first assessment subsets.

In block 242, for the one or more reference datasets of the selected cluster of reference datasets, from which reference scan parameter adjustments are extracted, one or more corresponding assessment datasets are identified with first assessment subset matching the respective first reference subsets, with second assessment subsets matching the respective second reference subsets, and with third assessment subsets matching the respective third reference subsets.

Here, matching may, e.g., refer to best matching the initial scan parameters, target parameters, and physical parameters of the definition dataset. Best matching refers to comprising the smallest deviations from the respective parameters of the respective reference dataset. For example, the assessment scan parameters, assessment target parameters, and physical assessment parameters may be identical to the initial reference scan parameters, reference target parameters, and physical reference parameters of the respective reference dataset.

In block 244, the effects of the recommended adjustment are determined regarding the signal-to-noise ratio and/or regarding the spatial resolution of magnetic resonance imaging data acquired by the acquisition to be executed. For this purpose, a comparison of the assessment magnetic resonance imaging data of the fourth assessment subsets of the identified assessment datasets with the reference magnetic resonance imaging data of the fifth reference subsets of the reference datasets of the selected cluster of reference datasets, from which reference scan parameter adjustments are extracted, may be used. For the determined effects the one or more effect indicators may be provided, which indicate the respective effects.

For example, a first signal-to-noise ratio of the assessment magnetic resonance imaging data and a second signal-to-noise ratio of the reference magnetic resonance imaging data may be determined. The first and second signal-to-noise ratio may be compared to determine the effect of the recommended adjustment on the signal-to-noise ratio of magnetic resonance imaging data acquired by the acquisition to be executed. The first signal-to-noise ratio may provide an estimate of the signal-to-noise ratio, in case the recommended adjustment is not applied, while the second signal-to-noise ratio may provide an estimate of the signal-to-noise ratio, in case the recommended adjustment is applied.

For example, a first spatial resolution of the assessment magnetic resonance imaging data and a second spatial resolution of the reference magnetic resonance imaging data may be determined. The first and second spatial resolution may be compared to determine the effect of the recommended adjustment on the spatial resolution of magnetic resonance imaging data acquired by the acquisition to be executed. The first spatial resolution may provide an estimate of the spatial resolution, in case the recommended adjustment is not applied, while the second spatial resolution may provide an estimate of the spatial resolution, in case the recommended adjustment is applied.

The identifying of the corresponding assessment datasets and the determining of the effects of the recommended adjustment regarding the signal-to-noise ratio and/or regarding the spatial resolution may, e.g., be executed by the recommendation module. The recommendation module may, e.g., further be configured, in response to receiving the definition dataset defining a magnetic resonance imaging data acquisition to be executed, to output the one or more indicators indicating the effect of the recommended adjustment on the signal-to-noise ratio and/ the spatial resolution of magnetic resonance imaging data acquired by the acquisition to be executed.

The identifying of the corresponding assessment datasets and the determining of the effects of the recommended adjustment regarding the signal-to-noise ratio and/or regarding the spatial resolution may, e.g., be executed by an additional assessment module stored in the memory of the medical system. The assessment module may, e.g., be configured, in response to receiving the extracted reference scan parameter adjustments as well as the fifth reference subsets of the reference datasets of the selected cluster of reference datasets, from which reference scan parameter adjustments are extracted, to output the one or more effect indicators indicating the effect of the recommended adjustment on the signal-to-noise ratio and/ the spatial resolution of magnetic resonance imaging data acquired by the acquisition to be executed.

Alternatively to providing a plurality of reference datasets, e.g., a clustered plurality of reference datasets stored in the memory of the medical system, the recommendation module may, e.g., comprise a machine learning module trained, using the plurality of reference datasets, to output the adjustment recommendation in response to receiving the definition dataset, e.g., in block 202 of Fig 1. Fig. 4 illustrates an exemplary method for provide the trained machine learning module. The method may, e.g., be executed by a medical system. An execution of machine-executable instructions stored in a memory of the medical system by a computational system of the medical system may cause the computational system to provide the trained machine learning module.

In block 260, the plurality of reference datasets may be received as training datasets for training the machine learning module. Each of the reference datasets used as training datasets may comprise a first reference subset comprising one or more initial reference scan parameters proposed for the respective reference magnetic resonance imaging data acquisition, which are used as one or more initial training scan parameters proposed for a respective training magnetic resonance imaging data acquisition. Each of the reference datasets used as training datasets may further comprise a second reference subset comprising one or more reference target parameters defining a physiological target type of the respective reference magnetic resonance imaging data acquisition, which are used as one or more training target parameters defining a physiological target type of the respective training magnetic resonance imaging data acquisition. Each of the reference datasets used as training datasets may further comprise a third reference subset comprising one or more physical reference parameters of a subject, from which magnetic resonance imaging data is acquired by the respective reference magnetic resonance imaging data acquisition, which are used as one or more physical training parameters of a subject, from which magnetic resonance imaging data is acquired by the respective training magnetic resonance imaging data acquisition. Each of the reference datasets used as training datasets may further comprise a fourth reference subset comprising one or more reference scan parameter adjustments applied to the initial reference scan parameters of the respective reference magnetic resonance imaging data acquisition, which are used as one or more training scan parameter adjustments applied to the initial training scan parameters of the respective training magnetic resonance imaging data acquisition.

In block 262, the machine learning module is trained to output the one or more reference scan parameter adjustments of the fourth reference subsets of the reference datasets, which are used as training datasets, as adjustment recommendations for an adjustment of at least some of the one or more initial reference scan parameters of the first reference subset of the respective reference datasets in response to receiving the first, second and third reference subsets of the respective reference datasets.

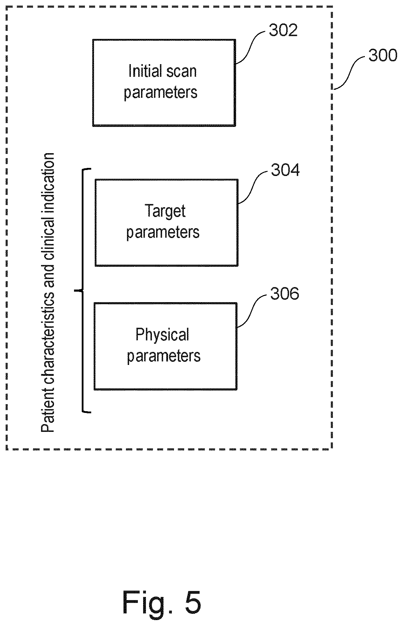

Fig. 5 illustrates an exemplary definition dataset 300. The definition dataset 300 defines a magnetic resonance imaging data acquisition to be executed. The exemplary definition dataset 300 comprises a first subset 302, a second subset 304 and a third subset 306. The first subset 302 comprises one or more initial scan parameters proposed for the magnetic resonance imaging data acquisition. The one or more initial scan parameters may, e.g., comprise one or more initial scan parameters defining one or more basic pulse sequence parameters, like one or more Times to Echo (TE) and/or one or more Repetition Times (TR). Furthermore, the one or more initial scan parameters may, e.g., comprise one or more initial parameters defining one or more of the following: one or more Times to Echo (TE); one or more Repetition Times (TR); one or more flip angles; one or more Inversion Times (TI); a number of acquisitions, i.e., a number of averages used; one or more scan geometry matrices; one or more slice dimensions.

The second subset 304 comprises one or more target parameters defining a physiological target type of the magnetic resonance imaging data acquisition. These target parameters may, e.g., be descriptive of a clinical indication. The one or more target parameters may, e.g., comprise one or more target parameters defining one or more of the following: one or more internal organs, such as liver, kidney, heart, brain, etc., and/or one or more sections of the one or more internal organs; a clinical indication, such as a morphological state, an oncological state and/or a functional state, such as a cardiac function, of the respective internal organ, which is to be determined using the MRI data to be acquired.

The third subset 306 comprises one or more physical parameters of a subject, from which magnetic resonance imaging data is to be acquired by the respective magnetic resonance imaging data acquisition. These physical parameters may, e.g., be descriptive of patient characteristics. The one or more physical parameters may, e.g., comprise one or more physical parameters defining one or more of the following: one or more general physical features of a subject, such as age, sex, weight, height; one or more physical abilities, such as an ability to hold breath; one or more features of physical constitution of the subject, such as a tremor, a low or high blood pressure, etc.

The subsets 302 to 306 and thus the definition dataset 300 may, e.g., be provided in form of a single file or in distributed form comprising a plurality of files. For example, subsets 302 to 306 may be provided in form of a plurality of files.

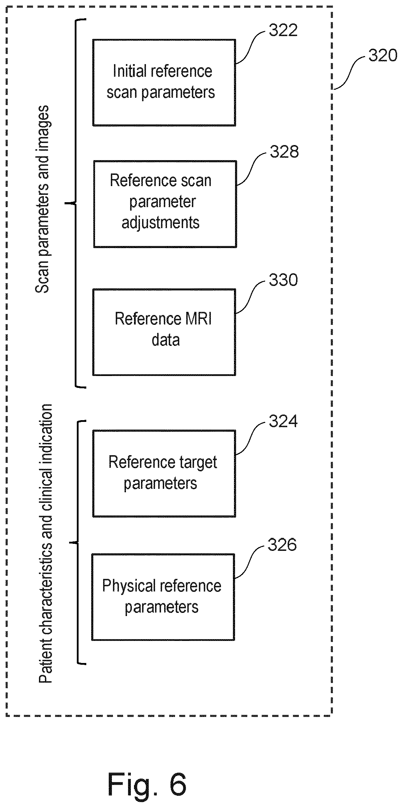

Fig. 6 illustrates an exemplary reference dataset 320. The reference dataset 320 describes a reference magnetic resonance imaging data acquisition, e.g., a magnetic resonance imaging data acquisition actually executed, under the control of a peer operator. The exemplary reference dataset 320 comprises a first reference subset 322, a second reference subset 324, a third reference subset 326, a fourth reference subset 328, and a fifth reference subset 330.

The first reference subset 322 comprises one or more initial reference scan parameters proposed for the respective reference magnetic resonance imaging data acquisition. The one or more initial reference scan parameters may, e.g., comprise one or more initial reference scan parameters defining one or more of the following features of the reference MRI data acquisition: one or more Times to Echo (TE); one or more Repetition Times (TR); one or more flip angles; one or more Inversion Times (TI); a number of acquisitions, i.e., a number of averages used; one or more scan geometry matrices; one or more slice dimensions.

The second reference subset 324 comprises one or more reference target parameters defining a physiological target type of the respective reference magnetic resonance imaging data acquisition. These reference target parameters may, e.g., be descriptive of a clinical indication. The one or more reference target parameters may, e.g., comprise one or more reference target parameters defining one or more of the following features of a physiological target type of the reference MRI data acquisition: one or more internal organs, such as liver, kidney, heart, brain, etc., and/or one or more sections of the one or more internal organs; a clinical indication, such as a morphological state, an oncological state and/or a functional state, such as a cardiac function, of the respective internal organ, to be determined using the reference MRI data acquisition.

The third reference subset 326 comprises one or more physical reference parameters of a subject, from which magnetic resonance imaging data is acquired by the respective reference magnetic resonance imaging data acquisition. These physical reference parameters may, e.g., be descriptive of patient characteristics. The one or more physical reference parameters may, e.g., comprise one or more physical parameters defining one or more of the following features of the subject of the reference MRI data acquisition: one or more general physical features of a subject, such as age, sex, weight, height; one or more physical abilities, such as an ability to hold breath; one or more features of physical constitution of the subject, such as a tremor, a low or high blood pressure, etc.

The fourth reference subset 328 comprises one or more reference scan parameter adjustments applied to the initial scan parameters of the first subset 322, i.e., of the respective reference magnetic resonance imaging data acquisition. The one or more reference scan parameter adjustments may, e.g., comprise one or more reference scan parameter adjustments descriptive of one or more adjustments applied to the following one or more initial reference scan parameters of reference MRI data acquisition: one or more Times to Echo (TE); one or more Repetition Times (TR); one or more flip angles; one or more Inversion Times (TI); a number of acquisitions, i.e., a number of averages used; one or more scan geometry matrices; one or more slice dimensions. These reference scan parameter adjustments may, e.g., be adjustments applied to the initial reference scan parameters of the respective reference MRI data acquisition to improve one or more of the following: a total scan time, a signal-to-noise ratio and/or a spatial resolution of the respective MRI data acquisition.

The fifth reference subsets 330 comprises reference magnetic resonance imaging data acquired using the reference initial scan parameters of the first reference subset 322, which have been adjusted using the reference scan parameter adjustments of the fourth reference subsets 328. The reference initial scan parameters of the first reference subset 322 in combination with the reference scan parameter adjustments of the fourth reference subsets 328 may, e.g., be descriptive of the actual scan parameters used to acquire the reference magnetic resonance imaging data, e.g., reference MR images, of the fifth reference subsets 330.

The reference subsets 322 to 330 and thus the reference dataset 320 may, e.g., be provided in form of a single file or in distributed form comprising a plurality of files. For example, reference subsets 322 to 330 may be provided in form of a plurality of files.

For example, the reference dataset 320 may be used as a training dataset. The first reference subset 322 comprising the initial reference scan parameters proposed for the respective reference magnetic resonance imaging data acquisition may be used as a first training subset with one or more initial training scan parameters proposed for a respective training magnetic resonance imaging data acquisition. The second reference subset 324 comprising the target parameters defining a physiological target type of the respective reference magnetic resonance imaging data acquisition may be used as a second training subset with one or more training target parameters defining a physiological target type of the respective training magnetic resonance imaging data acquisition. The third reference subset 326 comprising the reference parameters of a subject, from which magnetic resonance imaging data is acquired by the respective reference magnetic resonance imaging data acquisition, may be used as a third training subset with one or more physical training parameters of a subject, from which magnetic resonance imaging data is acquired by the respective training magnetic resonance imaging data acquisition. The fourth reference subset 328 comprising one or more reference scan parameter adjustments applied to the initial reference scan parameters of the respective reference magnetic resonance imaging data acquisition may be used as a fourth training subset with one or more training scan parameter adjustments applied to the initial training scan parameters of the respective training magnetic resonance imaging data acquisition.

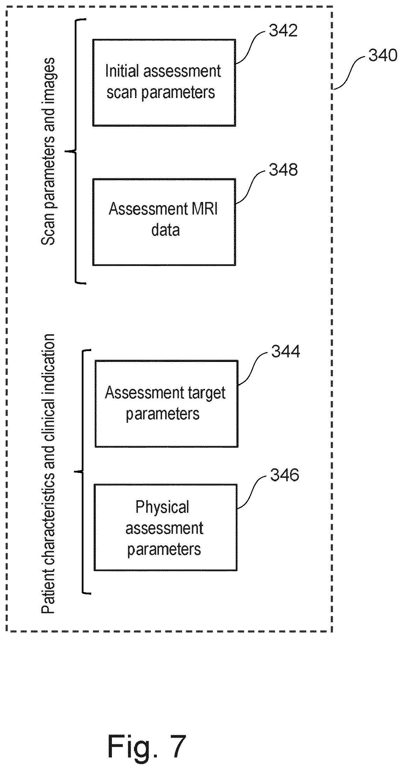

Fig. 7 illustrates an exemplary assessment dataset 340. The assessment dataset 340 describes a magnetic resonance imaging data acquisition actually executed, e.g., under the control of a peer operator. The assessment dataset 340 may be used for assessing an effect of adjusting reference initial scan parameter of a reference dataset, like the reference dataset 320 of Fig. 6, using reference scan parameter adjustments of the respective reference dataset. The exemplary assessment dataset 340 comprises a first assessment subset 342, a second assessment subset 344, a third assessment subset 346, and a fourth assessment subset 348.

The first assessment subset 342 comprises one or more assessment scan parameters used for executing the respective magnetic resonance imaging data acquisition. The one or more assessment scan parameters may, e.g., comprise one or more assessment scan parameters defining one or more of the following features of the assessment MRI data acquisition: one or more Times to Echo (TE); one or more Repetition Times (TR); one or more flip angles; one or more Inversion Times (TI); a number of acquisitions, i.e., a number of averages used; one or more scan geometry matrices; one or more slice dimensions.

The second assessment subset 344 comprises one or more assessment target parameters defining a physiological target type of the respective magnetic resonance imaging data acquisition. These assessment target parameters may, e.g., be descriptive of a clinical indication. The one or more assessment target parameters may, e.g., comprise one or more assessment target parameters defining one or more of the following features of a physiological target type of the assessment MRI data acquisition: one or more internal organs, such as liver, kidney, heart, brain, etc., and/or one or more sections of the one or more internal organs; a clinical indication, such as a morphological state, an oncological state and/or a functional state, such as a cardiac function, of the respective internal organ, to be determined using the assessment MRI data acquisition.

The third assessment subset 346 comprises one or more physical assessment parameters of a subject, from which magnetic resonance imaging data is acquired by the respective magnetic resonance imaging data acquisition. These physical assessment parameters may, e.g., be descriptive of patient characteristics. The one or more physical assessment parameters may, e.g., comprise one or more physical parameters defining one or more of the following features of the subject of the assessment MRI data acquisition: one or more general physical features of a subject, such as age, sex, weight, height; one or more physical abilities, such as an ability to hold breath; one or more features of physical constitution of the subject, such as a tremor, a low or high blood pressure, etc.

The fourth assessment subset 348 comprises assessment magnetic resonance imaging data acquired using the assessment scan parameters of the first assessment subset 342. The assessment scan parameters of the first assessment subset 342 are the scan parameters used to acquire the assessment magnetic resonance imaging data, e.g., reference MR images, of the fourth assessment subsets 348.

The assessment subsets 342 to 348 and thus the assessment dataset 340 may, e.g., be provided in form of a single file or in distributed form comprising a plurality of files. For example, assessment subsets 342 to 348 may be provided in form of a plurality of files.

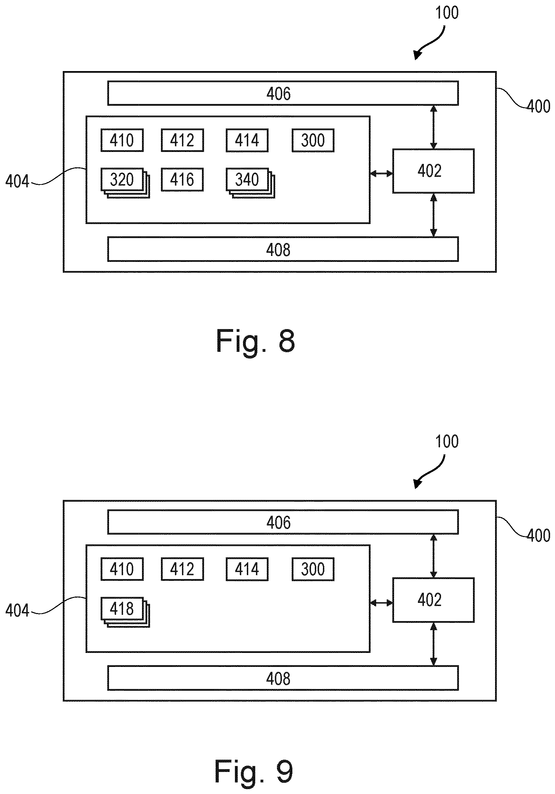

Fig. 8 illustrates an example of a medical system 100. The medical system 100 is shown as comprising a computer 400. The computer 400 may be one or more computers located at one or more locations. In some examples the computer 400 could be accessible via a network or the internet. For example, it may be used for providing a cloud-based service. The computer 400 is shown as comprising a computational system 402. The computational system 402 is intended to represent one or more computational systems or computing cores located at one or more locations. The computational system 402 is shown as being connected to an optional hardware interface 406. The hardware interface 406 may be used to control other components such as a magnetic resonance imaging system if they are present. The computational system 402 is further shown as being connected to an optional user interface. The user interface 408 may be used for such things as displaying or rendering magnetic resonance images or for providing a user interface for controlling and operating the medical system 100. The computational system 402 is further shown as being connected to a memory 404. The memory 404 is intended to represent various types of memory accessible to the computational system 403. In one example the memory 404 is a non-transitory storage medium.

The memory 404 is shown as storing machine-executable instructions 410. The machine-executable instructions 410 enable the computational system 402 to control other components of the medical system 100 as well as perform various numerical and image processing tasks. For example, the machine-executable instructions 410 enable the computational system 402 to control the medical system to execute any of the exemplary methods of Fig. 1 to Fig. 3. The memory 404 is further shown as containing a recommendation module 412. The recommendation module 412 may be configured, in response to receiving as input a definition dataset 300 defining a magnetic resonance imaging data acquisition to be executed, to output an adjustment recommendation 414 for an adjustment of at least some initial scan parameters of a first subset of the definition dataset 300 with one or more initial scan parameters proposed for the magnetic resonance imaging data acquisition. The definition dataset 300 may, e.g., have the form of the exemplary definition dataset 300 illustrated in Fig. 5. The definition dataset 300 may comprise the first subset, a second subset with one or more target parameters defining a physiological target type of the magnetic resonance imaging data acquisition, and a third subset with one or more physical parameters of a subject, from which magnetic resonance imaging data is to be acquired by the respective magnetic resonance imaging data acquisition. An execution of the machine-executable instructions 410 by the computational system 402 may cause the computational system 402 to receive the definition dataset 300, to provide the adjustment recommendation 414 using the definition dataset 300 and the recommendation module 412, and to adjust the at least some initial scan parameters of the first subset of the definition dataset 300 using the adjustment recommendation 414.

The memory 404 is further shown as containing a clustered plurality of reference datasets 320 of a plurality of reference magnetic resonance imaging data acquisitions. The reference datasets 320 may, e.g., have the form of the exemplary reference dataset 320 illustrated in Fig. 6. Each of the reference datasets 320 may comprise a first reference subset with one or more initial reference scan parameters proposed for the respective reference magnetic resonance imaging data acquisition. Each of the reference datasets 320 may further comprise a second reference subset with one or more reference target parameters defining a physiological target type of the respective reference magnetic resonance imaging data acquisition. Each of the reference datasets 320 may further comprise a third reference subset with one or more physical reference parameters of a subject, from which magnetic resonance imaging data is acquired by the respective reference magnetic resonance imaging data acquisition. Each of the reference datasets 320 may further comprise a fourth reference subset comprising one or more reference scan parameter adjustments applied to the initial reference scan parameters of the respective reference magnetic resonance imaging data acquisition. The reference datasets 320 may be clustered using the initial reference scan parameters of the first reference subsets, the reference target parameters of the second reference subsets, and the physical reference parameters of the third reference subsets.

The execution of the machine-executable instructions 410 by the computational system 402 may further cause the computational system 402 to select by the recommendation module 412 a cluster of reference datasets 320 from the clustered plurality of reference datasets 320. Selection parameters used for the selecting may comprise at least some of the following: the one or more initial scan parameters of the first subset, the one or more target parameters of the second subset, and the one or more physical parameters of the third subset of the definition dataset 300.

The execution of the machine-executable instructions 410 by the computational system 402 may further extract by the recommendation module 412 one or more reference scan parameter adjustments comprised by one or more fourth reference subsets of the reference datasets 320 of the selected cluster. The providing of the adjustment recommendation 414 comprises using the extracted one or more reference scan parameter adjustments.

For example, the execution of the machine-executable instructions 410 by the computational system 402 may further cause the computational system 402 to provide the stored clustered plurality of reference datasets 320. The providing of the stored clustered plurality of reference datasets 320 may, e.g., comprise receiving the plurality of reference datasets 320, clustering the plurality of reference datasets 320, and storing the resulting clustered plurality of reference datasets 320.

For example, the reference datasets 320 may further comprise fifth reference subsets. The fifth reference subsets may comprise reference magnetic resonance imaging data acquired using the reference initial scan parameters of the first reference subsets of the respective reference datasets 320, which have been adjusted using the reference adjustment parameters of the fourth reference subsets of the respective reference datasets 320.

For example, the reference datasets 320 may further be assigned with quality indicators. The quality indicators may, e.g., indicate a total scan time of the magnetic resonance imaging data acquisition using the reference initial scan parameters of the first reference subsets, which have been adjusted using the reference adjustment parameters of the fourth reference subsets. The quality indicators may, e.g., indicate a signal-to-noise ratio of reference magnetic resonance imaging data acquired using the reference initial scan parameters of the first reference subsets, which have been adjusted using the reference adjustment parameters of the fourth reference subsets. The quality indicators may, e.g., indicate a spatial resolution of reference magnetic resonance imaging data acquired using the reference initial scan parameters of the first reference subsets, which have been adjusted using the reference adjustment parameters of the fourth reference subsets. For determining the quality indicators, the reference magnetic resonance imaging data of the fifth reference subsets may be used for determining at least some of the quality indicators, e.g., quality indicators indicating a signal-to-noise ratio and/or indicators indicating a spatial resolution of the respective reference magnetic resonance imaging data.

The memory 404 is further shown as containing one or more effect indicators 416 indicating one or more effects of the recommended adjustment 414 of the initial scan parameters of the first subset on the magnetic resonance imaging data acquisition to be executed, i.e. of the definition dataset 300. For example, the one or more effect indicators 416 may be provided in addition to the adjustment recommendation 414. The one or more effect indicators 416 may, e.g., indicate an effect of the recommended adjustment 414 on a scan time of the magnetic resonance imaging data acquisition to be executed. For example, the effect of the recommended adjustment 414 on the scan time may be determined using a comparison of the at least some initial scan parameters with and without the adjustments according to the adjustment recommendation 414.

For example, the one or more effect indicators 416 indicate an effect of the recommended adjustment 414 on magnetic resonance imaging data acquired by the acquisition to be executed regarding one or more of the following parameters: a signal-to-noise ratio, a spatial resolution.

The memory 404 is further shown as containing a plurality of assessment datasets 340 of a plurality of magnetic resonance imaging data acquisitions. The assessment datasets 340 may, e.g., have the form of the exemplary assessment dataset 340 illustrated in Fig. 7. Each of the assessment datasets 340 may comprise a first assessment subset with one or more assessment scan parameters used for executing the respective magnetic resonance imaging data acquisition. Each of the assessment datasets 340 may further comprise a second assessment subset with one or more assessment target parameters defining a physiological target type of the respective magnetic resonance imaging data acquisition. Each of the assessment datasets 340 may further comprise a third assessment subset with one or more physical assessment parameters of a subject, from which magnetic resonance imaging data is acquired by the respective magnetic resonance imaging data acquisition. Each of the assessment datasets 340 may further comprise a fourth assessment subset comprising assessment magnetic resonance imaging data acquired using the assessment scan parameters of the first assessment subsets.

The execution of the machine-executable instructions 410 by the computational system 402 may further cause the computational system 402 to receive the plurality of assessment datasets 340 of a plurality of magnetic resonance imaging data acquisitions. The execution of the machine-executable instructions 410 by the computational system 402 may further cause the computational system 402 to identifying for the one or more reference datasets 340 of the selected cluster of reference datasets 340, from which reference scan parameter adjustments are extracted, one or more corresponding assessment datasets 340 with first assessment subset matching the respective first reference subsets, with second assessment subsets matching the respective second reference subsets, and with third assessment subsets matching the respective third reference subsets. The execution of the machine-executable instructions 410 by the computational system 402 may further cause the computational system 402 to using a comparison of the assessment magnetic resonance imaging data of the fourth assessment subsets of the identified one or more corresponding assessment datasets with the reference magnetic resonance imaging data of the fifth reference subsets of the one or more reference datasets of the selected cluster of reference datasets, from which reference scan parameter adjustments are extracted, for determining the effect of the recommended adjustment on magnetic resonance imaging data acquired by the acquisition to be executed.

Fig. 9 illustrates another example of a medical system 100. The medical system 100 is shown as comprising a computer 400. The computer 400 may be one or more computers located at one or more locations. In some examples the computer 400 could be accessible via a network or the internet. For example, it may be used for providing a cloud-based service. The computer 400 is shown as comprising a computational system 402. The computational system 402 is intended to represent one or more computational systems or computing cores located at one or more locations. The computational system 402 is shown as being connected to an optional hardware interface 406. The hardware interface 406 may be used to control other components such as a magnetic resonance imaging system if they are present. The computational system 402 is further shown as being connected to an optional user interface. The user interface 408 may be used for such things as displaying or rendering magnetic resonance images or for providing a user interface for controlling and operating the medical system 100. The computational system 402 is further shown as being connected to a memory 404. The memory 404 is intended to represent various types of memory accessible to the computational system 403. In one example the memory 404 is a non-transitory storage medium.

The memory 404 is shown as storing machine-executable instructions 410. The machine-executable instructions 410 enable the computational system 402 to control other components of the medical system 100 as well as perform various numerical and image processing tasks. For example, the machine-executable instructions 410 enable the computational system 402 to control the medical system to execute any of the exemplary methods of Fig. 1 and Fig. 4. The memory 404 is further shown as containing a recommendation module 412. The recommendation module 412 may be configured, in response to receiving as input a definition dataset 300 defining a magnetic resonance imaging data acquisition to be executed, to output an adjustment recommendation 414 for an adjustment of at least some initial scan parameters of a first subset of the definition dataset 300 with one or more initial scan parameters proposed for the magnetic resonance imaging data acquisition. The definition dataset 300 may, e.g., have the form of the exemplary definition dataset 300 illustrated in Fig. 5. The definition dataset 300 may comprise the first subset, a second subset with one or more target parameters defining a physiological target type of the magnetic resonance imaging data acquisition, and a third subset with one or more physical parameters of a subject, from which magnetic resonance imaging data is to be acquired by the respective magnetic resonance imaging data acquisition. An execution of the machine-executable instructions 410 by the computational system 402 may cause the computational system 402 to receive the definition dataset 300, to provide the adjustment recommendation 414 using the definition dataset 300 and the recommendation module 412, and to adjust the at least some initial scan parameters of the first subset of the definition dataset 300 using the adjustment recommendation 414.

For example, the recommendation module 412 may comprise a machine learning module trained, using a plurality of reference datasets as training datasets, to output the adjustment recommendation 414 in response to receiving the definition dataset 300. The memory 404 is further shown as containing the plurality of training datasets 418 for training the machine learning module, i.e., reference datasets used as training datasets 418. Each of the training datasets 418 may comprise a first training subset with one or more initial training scan parameters proposed for the respective training magnetic resonance imaging data acquisition, i.e., a first reference subset with one or more initial reference scan parameters proposed for the respective reference magnetic resonance imaging data acquisition. Each of the training datasets 418 may further comprise a second training subset with one or more training target parameters defining a physiological target type of the respective training magnetic resonance imaging data acquisition, i.e., a second reference subset with one or more reference target parameters defining a physiological target type of the respective reference magnetic resonance imaging data acquisition. Each of the training datasets 418 may further comprise a third training subset with one or more physical training parameters of a subject, from which magnetic resonance imaging data is acquired by the respective training magnetic resonance imaging data acquisition, i.e., a third reference subset with one or more physical reference parameters of a subject, from which magnetic resonance imaging data is acquired by the respective reference magnetic resonance imaging data acquisition. Each of the training datasets 418 may further comprise a fourth training subset comprising one or more training scan parameter adjustments applied to the initial training scan parameters of the respective training magnetic resonance imaging data acquisition, i.e., a fourth reference subset with one or more reference scan parameter adjustments applied to the initial reference scan parameters of the respective reference magnetic resonance imaging data acquisition.

The execution of the machine-executable instructions 410 by the computational system 402 may further cause the computational system 402 to receive the training datasets 418 for training the machine learning module. The execution of the machine-executable instructions 410 by the computational system 402 may further cause the computational system 402 to training the machine learning module to output the one or more training scan parameter adjustments of the fourth training subsets of the training datasets 418 as adjustment recommendations for an adjustment of at least some of the one or more initial training scan parameters of the first training subset of the respective training datasets 418 in response to receiving the first, second and third training subsets of the respective training datasets 418.

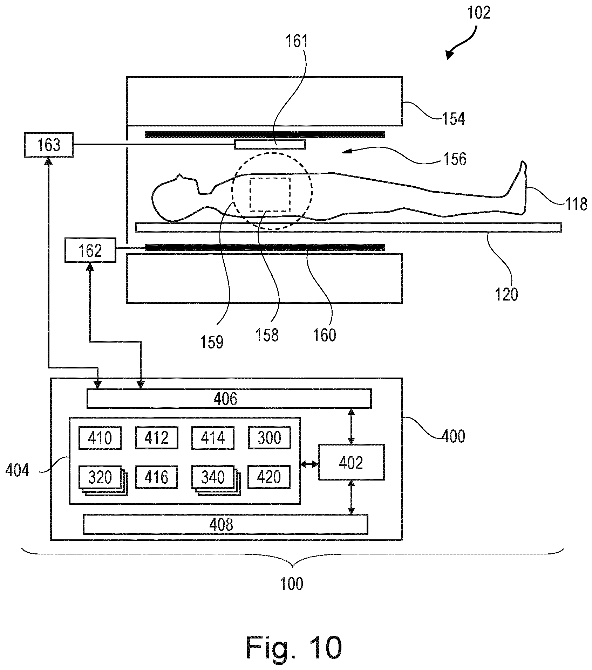

Fig. 10 illustrates another exemplary magnetic resonance imaging system 100. The medical system 100 of Fig. 10 is similar to the medical system 100 depicted in Fig. 8 except that it additionally comprises a magnetic resonance imaging system 102, which is being controlled by the hardware interface 406. The magnetic resonance imaging system 102 comprises a magnet 154. The magnet 154 is a superconducting cylindrical type of magnet with a bore 156 through it. The use of different types of magnets is also possible. For instance, it is also possible to use both a split cylindrical magnet and a so-called open magnet. A split cylindrical magnet is similar to a standard cylindrical magnet, except that the cryostat has been split into two sections to allow access to the iso-plane of the magnet, such magnets may for instance be used in conjunction with charged particle beam therapy. An open magnet has two magnet sections, one above the other with a space in-between that is large enough to receive a subject: the arrangement of the two sections area similar to that of a Helmholtz coil. Open magnets are popular, because the subject is less confined. Inside the cryostat of the cylindrical magnet there is a collection of superconducting coils.

Within the bore 156 of the cylindrical magnet 154 there is an imaging zone 159, where the magnetic field is strong and uniform enough to perform magnetic resonance imaging. A field of view 158 is shown within the imaging zone 159. The magnetic resonance data is typically acquired for the field of view 158. A subject 118 is shown as being supported by a subject support 120 such that at least a portion of the subject 118 is within the imaging zone 159 and the field of view 158.

Within the bore 156 of the magnet there is also a set of magnetic field gradient coils 160 which is used for the acquisition of preliminary magnetic resonance imaging data to spatially encode magnetic spins within the bore 156 of the magnet 154. The magnetic field gradient coils 160 are connected to a gradient controller, i.e., a magnetic field gradient coil power supply 162. The magnetic field gradient coils 160 are intended to be representative. Typically, magnetic field gradient coils 160 contain three separate sets of coils for spatial encoding in three orthogonal spatial directions. The magnetic field gradient power supply 162 supplies current to the magnetic field gradient coils 160. The current supplied to the magnetic field gradient coils 160 is controlled as a function of time and may be ramped or pulsed.

Adjacent to the imaging zone 159 is a radio-frequency antenna 161 arranged for manipulating the orientations of magnetic spins within the imaging zone 159 and for receiving radio transmissions from spins also within the imaging zone 159. The radio-frequency antenna 161may contain multiple coil elements. The radio-frequency antenna 161 is connected to a radio-frequency transceiver 163. The radio-frequency antenna 161 and radio- frequency transceiver 163 may be replaced by separate transmit and receive coils and a separate transmitter and receiver. It is understood that the radio-frequency antenna 161 and the radio- frequency transceiver 163 are representative. The radio-frequency antenna 161 is intended to also represent a dedicated transmit antenna and a dedicated receive antenna. Likewise, the transceiver 163 may also represent a separate transmitter and receivers. The radio-frequency antenna 161 may also have multiple receive/transmit elements and the radio- frequency transceiver 163 may have multiple receive/transmit channels. The transceiver 163 and the gradient controller 162 are shown as being connected to the hardware interface 406 of the computer 400.

The execution of the machine-executable instructions 410 by the computational system 402 may further cause the computational system 402 to acquire magnetic resonance data 420 using the initial scan parameters of the definition dataset 300, which have been adjusted using the adjustment recommendation 414.

The medical system 100 of Fig. 10 may alternatively comprise the computer 400 of Fig. 9 replacing the computer 400 depicted in in Fig. 10, which corresponds to the computer 400 of Fig. 8. In that case, the medical system 100 of Fig. 10 would be similar to the medical system 100 depicted in Fig. 8 except that it additionally comprises a magnetic resonance imaging system 102, which is being controlled by the hardware interface 406.

It is understood that one or more of the aforementioned examples or embodiments of the invention may be combined as long as the combined embodiments are not mutually exclusive.

As will be appreciated by one skilled in the art, aspects of the present invention may be embodied as an apparatus, method or computer program product. Accordingly, aspects of the present invention may take the form of an entirely hardware embodiment, an entirely software embodiment (including firmware, resident software, micro-code, etc.) or an embodiment combining software and hardware aspects that may all generally be referred to herein as a "circuit," "module" or "system." Furthermore, aspects of the present invention may take the form of a computer program product embodied in one or more computer-readable medium(s) having computer executable code embodied thereon.

Any combination of one or more computer-readable medium(s) may be utilized. The computer-readable medium may be a computer-readable signal medium or a computer-readable storage medium. A `computer-readable storage medium' as used herein encompasses any tangible storage medium which may store instructions which are executable by a processor or computational system of a computing device. The computer-readable storage medium may be referred to as a computer-readable non-transitory storage medium. The computer-readable storage medium may also be referred to as a tangible computer-readable medium. In some embodiments, a computer-readable storage medium may also be able to store data which is able to be accessed by the computational system of the computing device. Examples of computer-readable storage media include, but are not limited to: a floppy disk, a magnetic hard disk drive, a solid-state hard disk, flash memory, a USB thumb drive, Random Access Memory (RAM), Read Only Memory (ROM), an optical disk, a magneto-optical disk, and the register file of the computational system. Examples of optical disks include Compact Disks (CD) and Digital Versatile Disks (DVD), for example CD-ROM, CD-RW, CD-R, DVD-ROM, DVD-RW, or DVD-R disks. The term computer-readable-storage medium also refers to various types of recording media capable of being accessed by the computer device via a network or communication link. For example, data may be retrieved over a modem, over the internet, or over a local area network. Computer executable code embodied on a computer-readable medium may be transmitted using any appropriate medium, including but not limited to wireless, wire line, optical fiber cable, RF, etc., or any suitable combination of the foregoing.

A computer-readable signal medium may include a propagated data signal with computer executable code embodied therein, for example, in baseband or as part of a carrier wave. Such a propagated signal may take any of a variety of forms, including, but not limited to, electro-magnetic, optical, or any suitable combination thereof. A computer-readable signal medium may be any computer-readable medium that is not a computer-readable storage medium and that can communicate, propagate, or transport a program for use by or in connection with an instruction execution system, apparatus, or device.

`Computer memory' or 'memory' is an example of a computer-readable storage medium. Computer memory is any memory which is directly accessible to a computational system. `Computer storage' or 'storage' is a further example of a computer-readable storage medium. Computer storage is any non-volatile computer-readable storage medium. In some embodiments computer storage may also be computer memory or vice versa.

A `computational system' as used herein encompasses an electronic component which is able to execute a program or machine-executable instruction or computer executable code. References to the computational system comprising the example of "a computational system" should be interpreted as possibly containing more than one computational system or processing core. The computational system may for instance be a multi-core processor. A computational system may also refer to a collection of computational systems within a single computer system or distributed amongst multiple computer systems. The term computational system should also be interpreted to possibly refer to a collection or network of computing devices each comprising a processor or computational systems. The machine-executable code or instructions may be executed by multiple computational systems or processors that may be within the same computing device or which may even be distributed across multiple computing devices.

Machine-executable instructions or computer executable code may comprise instructions or a program which causes a processor or other computational system to perform an aspect of the present invention. Computer executable code for carrying out operations for aspects of the present invention may be written in any combination of one or more programming languages, including an object-oriented programming language such as Java, Smalltalk, C++, or the like and conventional procedural programming languages, such as the "C" programming language or similar programming languages and compiled into machine-executable instructions. In some instances, the computer executable code may be in the form of a high-level language or in a pre-compiled form and be used in conjunction with an interpreter which generates the machine-executable instructions on the fly. In other instances, the machine-executable instructions or computer executable code may be in the form of programming for programmable logic gate arrays.

The computer executable code may execute entirely on the user's computer, partly on the user's computer, as a stand-alone software package, partly on the user's computer and partly on a remote computer or entirely on the remote computer or server. In the latter scenario, the remote computer may be connected to the user's computer through any type of network, including a Local Area Network (LAN) or a Wide Area Network (WAN), or the connection may be made to an external computer (for example, through the Internet using an Internet Service Provider).

Aspects of the present invention are described with reference to flowchart illustrations and/or block diagrams of methods, apparatus (systems) and computer program products according to embodiments of the invention. It is understood that each block or a portion of the blocks of the flowchart, illustrations, and/or block diagrams, can be implemented by computer program instructions in form of computer executable code when applicable. It is further understood that, when not mutually exclusive, combinations of blocks in different flowcharts, illustrations, and/or block diagrams may be combined. These computer program instructions may be provided to a computational system of a general-purpose computer, special purpose computer, or other programmable data processing apparatus to produce a machine, such that the instructions, which execute via the computational system of the computer or other programmable data processing apparatus, create means for implementing the functions/acts specified in the flowchart and/or block diagram block or blocks.

These machine-executable instructions or computer program instructions may also be stored in a computer-readable medium that can direct a computer, other programmable data processing apparatus, or other devices to function in a particular manner, such that the instructions stored in the computer-readable medium produce an article of manufacture including instructions which implement the function/act specified in the flowchart and/or block diagram block or blocks.

The machine-executable instructions or computer program instructions may also be loaded onto a computer, other programmable data processing apparatus, or other devices to cause a series of operational steps to be performed on the computer, other programmable apparatus or other devices to produce a computer implemented process such that the instructions which execute on the computer or other programmable apparatus provide processes for implementing the functions/acts specified in the flowchart and/or block diagram block or blocks.

A `user interface' as used herein is an interface which allows a user or operator to interact with a computer or computer system. A `user interface' may also be referred to as a 'human interface device.' A user interface may provide information or data to the operator and/or receive information or data from the operator. A user interface may enable input from an operator to be received by the computer and may provide output to the user from the computer. In other words, the user interface may allow an operator to control or manipulate a computer and the interface may allow the computer to indicate the effects of the operator's control or manipulation. The display of data or information on a display or a graphical user interface is an example of providing information to an operator. The receiving of data through a keyboard, mouse, trackball, touchpad, pointing stick, graphics tablet, joystick, gamepad, webcam, headset, pedals, wired glove, remote control, and accelerometer are all examples of user interface components which enable the receiving of information or data from an operator.

A `hardware interface' as used herein encompasses an interface which enables the computational system of a computer system to interact with and/or control an external computing device and/or apparatus. A hardware interface may allow a computational system to send control signals or instructions to an external computing device and/or apparatus. A hardware interface may also enable a computational system to exchange data with an external computing device and/or apparatus. Examples of a hardware interface include but are not limited to: a universal serial bus, IEEE 1394 port, parallel port, IEEE 1284 port, serial port, RS-232 port, IEEE-488 port, Bluetooth connection, wireless local area network connection, TCP/IP connection, Ethernet connection, control voltage interface, MIDI interface, analog input interface, and digital input interface.

A 'display' or `display device' as used herein encompasses an output device or a user interface adapted for displaying images or data. A display may output visual, audio, and or tactile data. Examples of a display include, but are not limited to: a computer monitor, a television screen, a touch screen, tactile electronic display, Braille screen, Cathode Ray Tube (CRT), storage tube, bi-stable display, electronic paper, vector display, flat panel display, Vacuum Fluorescent (VF) display, Light-Emitting Diode (LED) displays, Electroluminescent display (ELD), Plasma Display Panels (PDP), Liquid Crystal Display (LCD), Organic Light-Emitting Diode (OLED) displays, a projector, and head-mounted display.

MRI data is defined herein as being the recorded measurements of RF signals emitted by atomic spins using the antenna of a magnetic resonance apparatus during an MRI scan. MRI data is an example of medical image data. An MR image is defined herein as being the reconstructed two- or three-dimensional visualization of anatomic data contained within the MRI data.

While the invention has been illustrated and described in detail in the drawings and foregoing description, such illustration and description are to be considered illustrative or exemplary and not restrictive; the invention is not limited to the disclosed embodiments.

Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. A single processor or other unit may fulfill the functions of several items recited in the claims. The mere fact that certain measures are recited in mutually different dependent claims does not indicate that a combination of these measures cannot be used to advantage. A computer program may be stored/distributed on a suitable medium, such as an optical storage medium or a solid-state medium supplied together with or as part of other hardware, but may also be distributed in other forms, such as via the Internet or other wired or wireless telecommunication systems. Any reference signs in the claims should not be construed as limiting the scope.

### REFERENCE SIGNS LIST

- 100: medical system
- 102: MRI system
- 118: subject
- 120: support
- 154: magnet
- 156: bore of magnet
- 158: field of view
- 159: imaging zone
- 160: magnetic field gradient coils
- 161: radio-frequency antenna
- 162: gradient controller
- 163: radio-frequency transceiver
- 300: definition dataset
- 302: first subset
- 304: second subset
- 306: third subset
- 320: reference dataset
- 322: first reference subset
- 324: second reference subset
- 326: third reference subset
- 328: fourth reference subset
- 330: fifth reference subset
- 340: assessment dataset
- 342: first assessment subset
- 344: second assessment subset
- 346: third assessment subset
- 348: fourth assessment subset
- 400: computer
- 402: computational system
- 404: memory
- 406: hardware interface
- 408: user interface
- 410: machine readable instructions
- 412: recommendation module
- 414: adjustment recommendation
- 416: effect indicator
- 418: training dataset
- 420: MRI data

## Claims

1. A medical system (100) comprising:
- a memory (404) storing machine-executable instructions (410) and a recommendation module (412), wherein the recommendation module (412) is configured, using a plurality of reference datasets (320) of a plurality of reference magnetic resonance imaging data acquisitions, to output an adjustment recommendation (414) for an adjustment of at least some initial scan parameters of a first subset (302) of a definition dataset (300), wherein the definition dataset (300) defines a magnetic resonance imaging data acquisition to be executed, wherein the recommendation module (412) is configured to output the adjustment recommendation (414) in response to receiving the definition dataset (300) as input,
wherein the definition dataset (300) comprises the first subset (302) with one or more initial scan parameters proposed for the magnetic resonance imaging data acquisition, a second subset (304) with one or more target parameters defining a physiological target type of the magnetic resonance imaging data acquisition, and a third subset (306) with one or more physical parameters of a subject (118), from which magnetic resonance imaging data is to be acquired by the respective magnetic resonance imaging data acquisition;
wherein each of the reference datasets (320) comprises a first reference subset (322) with one or more initial reference scan parameters proposed for the respective reference magnetic resonance imaging data acquisition, a second reference subset (324) with one or more reference target parameters defining a physiological target type of the respective reference magnetic resonance imaging data acquisition, a third reference subset (326) with one or more physical reference parameters of a subject (118), from which magnetic resonance imaging data is acquired by the respective reference magnetic resonance imaging data acquisition, and a fourth reference subset (328) with one or more reference scan parameter adjustments applied to the initial reference scan parameters of the respective reference magnetic resonance imaging data acquisition,
- a computational system (402), wherein an execution of the machine-executable instructions (410) causes the computational system (402) to:
- receive the definition dataset (300);
- provide the adjustment recommendation (414) using the definition dataset (300) and the recommendation module (412);
- adjust the at least some initial scan parameters of the first subset (302) using the adjustment recommendation (414).

2. The medical system (100) of claim 1, wherein the memory (404) further stores the plurality of reference datasets (320),
wherein the stored reference datasets (320) are clustered using the initial reference scan parameters of the first reference subsets (322), the reference target parameters of the second reference subsets (324), and the physical reference parameters of the third reference subsets (326),
wherein the providing of the adjustment recommendation (414) further comprises:
selecting by the recommendation module (412) a cluster of reference datasets (320) from the clustered plurality of reference datasets (320), wherein selection parameters used for the selecting comprise at least some of the following: the one or more initial scan parameters of the first subset (302), the one or more target parameters of the second subset (304), and the one or more physical parameters of the third subset (306),
extracting by the recommendation module (412) one or more reference scan parameter adjustments comprised by one or more fourth reference subsets (328) of the reference datasets (320) of the selected cluster, wherein the providing of the adjustment recommendation (414) comprises using the extracted one or more reference scan parameter adjustments.

3. The medical system (100) of claim 2, wherein the provided adjustment recommendation (414) comprises one or more of the extracted one or more reference scan parameter adjustments.

4. The medical system (100) of any of claim 2 to 3, wherein the providing of the adjustment recommendation (414) further comprises determining one or more approximated reference scan parameter adjustments using the extracted reference scan parameter adjustments, wherein the provided adjustment recommendation (414) comprises the determined one or more approximated reference scan parameter adjustments.

5. The medical system (100) of any of claims 2 to 4, wherein the execution of the machine-executable instructions (410) further causes the computational system (402) to provide the stored clustered plurality of reference datasets (320), wherein the providing of the stored clustered plurality of reference datasets (320) comprises:
receiving the plurality of reference datasets (320),
clustering the plurality of reference datasets (320),
storing the resulting clustered plurality of reference datasets (320).

6. The medical system (100) of any of the previous claims, wherein the providing of the adjustment recommendation (414) further comprises providing one or more effect indicators (416) indicating one or more effects of the recommended adjustment of the at least some initial scan parameters of the first subset (302) on the magnetic resonance imaging data acquisition to be executed.

7. The medical system (100) of claim 6, wherein the one or more effect indicators (416) indicate an effect of the recommended adjustment on a scan time of the magnetic resonance imaging data acquisition to be executed.

8. The medical system (100) of claim 7, wherein the effect of the recommended adjustment on the scan time is determined using a comparison of the at least some initial scan parameters with and without the adjustments according to the adjustment recommendation (414).

9. The medical system (100) of any of claims 6 to 8, wherein the one or more effect indicators (416) indicate an effect of the recommended adjustment on magnetic resonance imaging data acquired by the acquisition to be executed regarding one or more of the following parameters: a signal-to-noise ratio, a spatial resolution.

10. The medical system (100) of claim 9, wherein the reference datasets (320) further comprise fifth reference subsets (330) comprising reference magnetic resonance imaging data acquired using the reference initial scan parameters of the first reference subsets (322), which have been adjusted using the reference scan parameter adjustments of the fourth reference subsets (328),
wherein the execution of the machine-executable instructions (410) further causes the computational system (402) to:
receive a plurality of assessment datasets (340) of a plurality of magnetic resonance imaging data acquisitions, wherein each of the assessment datasets (340) comprises a first assessment subset (342) with one or more assessment scan parameters used for executing the respective magnetic resonance imaging data acquisition, a second assessment (344) subset with one or more assessment target parameters defining a physiological target type of the respective magnetic resonance imaging data acquisition, a third assessment (346) subset with one or more physical assessment parameters of a subject (118), from which magnetic resonance imaging data is acquired by the respective magnetic resonance imaging data acquisition, and a fourth assessment subset (348) with assessment magnetic resonance imaging data acquired using the assessment scan parameters of the first assessment subsets (342),
identify for the one or more reference datasets (320) of the selected cluster of reference datasets (320), from which reference scan parameter adjustments are extracted, one or more corresponding assessment datasets (340) with first assessment subset (342) matching the respective first reference subsets (322), with second assessment subsets (344) matching the respective second reference subsets (324), and with third assessment subsets (346) matching the respective third reference subsets (326),
use a comparison of the assessment magnetic resonance imaging data of the fourth assessment subsets (348) of the identified one or more corresponding assessment datasets (340) with the reference magnetic resonance imaging data of the fifth reference subsets (330) of the one or more reference datasets (320) of the selected cluster of reference datasets (320), from which reference scan parameter adjustments are extracted, for determining the effect of the recommended adjustment on magnetic resonance imaging data acquired by the acquisition to be executed.

11. The medical system (100) of claim 1, wherein the recommendation module (412) comprises a machine learning module trained, using the plurality of reference datasets (320), to output the adjustment recommendation (414) in response to receiving the definition dataset (300).

12. The medical system (100) of claim 11, wherein the execution of the machine-executable instructions (410) further causes the computational system (402) to provide the trained machine learning module, wherein the providing of the trained machine learning module comprises:
- receiving the plurality of reference datasets (320) as training datasets (418) for training the machine learning module;
- training the machine learning module to output the one or more reference scan parameter adjustments of the fourth reference subsets of the reference datasets (320) as adjustment recommendations (414) for an adjustment of at least some of the one or more initial reference scan parameters of the first reference subsets of the respective reference datasets (320) in response to receiving the first, second and third reference subsets of the respective reference datasets (320).

13. The medical system (100) of any of the previous claims, wherein the medical system (100) further comprises a magnetic resonance imaging system (102), wherein the execution of the machine-executable instructions (410) further causes the computational system (402) to:
- acquire magnetic resonance imaging data (420) using the adjusted at least some initial scan parameters of the first subset (302).

14. A computer program comprising machine-executable instructions (410) and a recommendation module (412), wherein the recommendation module (412) is configured, using a plurality of reference datasets (320) of a plurality of reference magnetic resonance imaging data acquisitions, to output an adjustment recommendation (414) for an adjustment of at least some initial scan parameters of a first subset (302) of a definition dataset (300), wherein the definition dataset (300) defines a magnetic resonance imaging data acquisition to be executed, wherein the recommendation module (412) is configured to output the adjustment recommendation (414) in response to receiving the definition dataset (300) as input,
wherein the definition dataset (300) comprises the first subset (302) with one or more initial scan parameters proposed for the magnetic resonance imaging data acquisition, a second subset (304) with one or more target parameters defining a physiological target type of the magnetic resonance imaging data acquisition, and a third subset (306) with one or more physical parameters of a subject (118), from which magnetic resonance imaging data is to be acquired by the respective magnetic resonance imaging data acquisition,
wherein each of the reference datasets (320) comprises a first reference subset (322) with one or more initial reference scan parameters proposed for the respective reference magnetic resonance imaging data acquisition, a second reference subset (324) with one or more reference target parameters defining a physiological target type of the respective reference magnetic resonance imaging data acquisition, a third reference subset (326) with one or more physical reference parameters of a subject (118), from which magnetic resonance imaging data is acquired by the respective reference magnetic resonance imaging data acquisition, and a fourth reference subset (328) with one or more reference scan parameter adjustments applied to the initial reference scan parameters of the respective reference magnetic resonance imaging data acquisition;
- wherein machine-executable instructions (410) are configured for causing a computational system (402) to:
- receive the definition dataset (300);
- provide the adjustment recommendation (414) using the definition dataset (300) and the recommendation module (412);
- adjust the at least some initial scan parameters of the first subset using the adjustment recommendation (414).

15. A method for controlling a medical system, wherein the medical system (100) comprises:
- a memory (404) storing machine-executable instructions (410) and a recommendation module (412), wherein the recommendation module (412) is configured, using a plurality of reference datasets (320) of a plurality of reference magnetic resonance imaging data acquisitions, to output an adjustment recommendation (414) for an adjustment of at least some initial scan parameters of a first subset (302) of a definition dataset (300), wherein the definition dataset (300) defines a magnetic resonance imaging data acquisition to be executed, wherein the recommendation module (412) is configured to output the adjustment recommendation (414) in response to receiving the definition dataset (300) as input,
wherein the definition dataset (300) comprises the first subset (302) with one or more initial scan parameters proposed for the magnetic resonance imaging data acquisition, a second subset (304) with one or more target parameters defining a physiological target type of the magnetic resonance imaging data acquisition, and a third subset (306) with one or more physical parameters of a subject (118), from which magnetic resonance imaging data is to be acquired by the respective magnetic resonance imaging data acquisition,
wherein each of the reference datasets (320) comprises a first reference subset (322) with one or more initial reference scan parameters proposed for the respective reference magnetic resonance imaging data acquisition, a second reference subset (324) with one or more reference target parameters defining a physiological target type of the respective reference magnetic resonance imaging data acquisition, a third reference subset (326) with one or more physical reference parameters of a subject (118), from which magnetic resonance imaging data is acquired by the respective reference magnetic resonance imaging data acquisition, and a fourth reference subset (328) with one or more reference scan parameter adjustments applied to the initial reference scan parameters of the respective reference magnetic resonance imaging data acquisition;
- a computational system (402), wherein an execution of the machine-executable instructions (410) causes the computational system (402) to execute the method comprising:
- receiving the definition dataset (300);
- providing the adjustment recommendation (414) using the definition dataset (300) and the recommendation module (412);
- adjusting the at least some initial scan parameters of the first subset (302) using the adjustment recommendation (414).
